# EUROPEAN PATENT SPECIFICATION

(11) **EP 2 757 600 B1**
(45) Date of publication and mention of the grant of the patent: **02.11.2016**
(21) Application number: 12832100.7
(22) Date of filing: 09.08.2012
(51) Int. Cl.: H01L 33/50, A01G 7/04, H01L 25/075, H01L 33/52

(54) **LIGHT EMITTING APPARATUS AND METHOD FOR MANUFACTURING SAME**
LICHTEMITTIERENDE VORRICHTUNG UND HERSTELLUNGSVERFAHREN DAFÜR
APPAREIL ÉMETTEUR DE LUMIÈRE ET SON PROCÉDÉ DE FABRICATION

(30) Priority: 14.09.2011 JP 2011201034
(43) Date of publication of application: 23.07.2014
(73) Proprietor: Sharp Kabushiki Kaisha, Osaka-shi, Osaka 545-8522 (JP)
(72) Inventor: HATA, Toshio, Osaka-shi, Osaka 545-8522 (JP); OSAKI, Shinji, Osaka-shi, Osaka 545-8522 (JP); UEMURA, Toyonori, Osaka-shi, Osaka 545-8522 (JP); ISHIZAKI, Shinya, Osaka-shi, Osaka 545-8522 (JP); MATSUDA, Makoto, Osaka-shi, Osaka 545-8522 (JP)
(74) Representative: Müller Hoffmann & Partner
(86) International application number: PCT/JP2012/070396
(87) International publication number: WO 2013/038854

(56) References cited:
- WO-A1-2010/053341
- JP-A- 2006 173 622
- JP-A- 2006 324 589
- JP-A- 2008 218 486
- JP-A- 2008 235 680
- JP-A- 2011 061 157
- JP-A- 2011 101 040

## Description

### Technical Field

The present invention relates to (i) a light emitting apparatus capable of emitting light having a plurality of spectra and (ii) a method of manufacturing the light emitting apparatus. Particularly, the present invention relates to (i) a light emitting apparatus capable of efficiently cultivating or culturing a specific photosynthetic living thing and (ii) a method of manufacturing the light emitting apparatus.

### Background Art

In recent years, light emitting apparatuses employing plural kinds of LEDs have been used as light sources for plant cultivation. In order to efficiently grow plants, it is preferable to use compound light rather than monochromatic light.

In view of this, as a method for generating compound light, the following methods have been conventionally known: a method for generating compound light by a combination of a red LED, a blue LED, and a green LED; and a method for generating compound light by a combination of a blue LED and a phosphor.

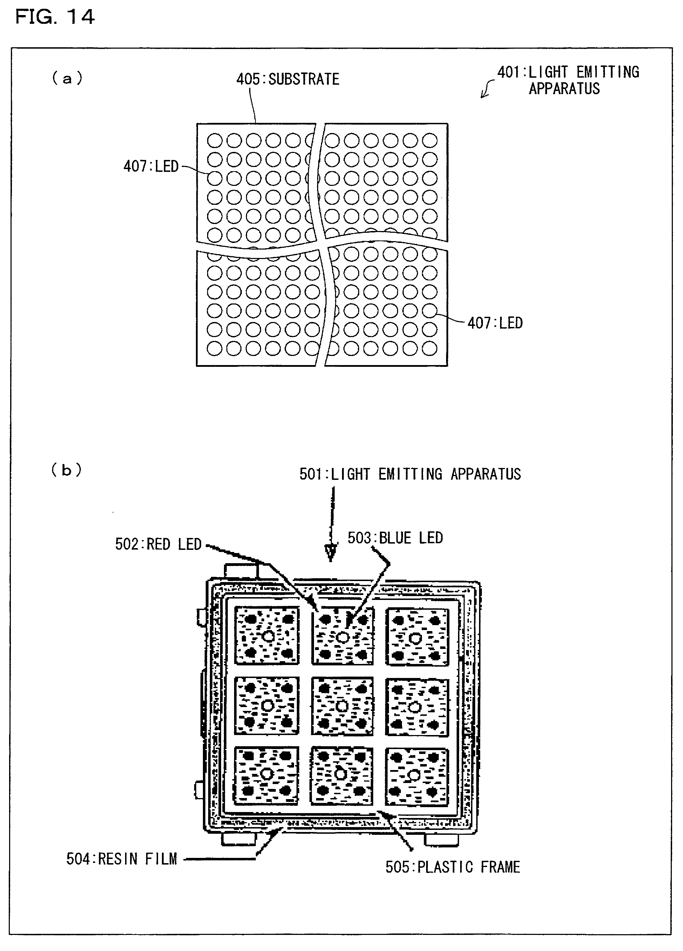

For example, Patent Literature 1 discloses a light emitting apparatus 401 for plant cultivation which is configured such that plural kinds of LEDs 407, each emitting light of a different spectrum, are provided on a substrate 405 (see (a) of Fig. 14). According to the light emitting apparatus 401, the plural kinds of LEDs 407 are provided so as to emit light toward a target plant.

Further, Patent Literature 2 discloses, as a light emitting apparatus for plant cultivation, a cover 501 of a cultivation container which cover 501 is configured such that red LEDs 502 and blue LEDs 503 are provided on a substrate (see (b) of Fig. 14). According to the cover 501, it is possible to control a ratio between a quantity of light from the red LEDs 502 and a quantity of light from the blue LEDs 503 in accordance with a species of a plant. For example, the cover 501 is arranged such that the quantity of light from the blue LEDs 503 is not exceed 50% of the quantity of light from the red LEDs 502. The red LEDs 502 are used solely, depending on a plant.

### Citation List

### Patent Literatures

Patent Literature 1
   Japanese Patent Application Publication, Tokukai, No. 2004-344114 A (Publication Date: December 9, 2004)
Patent Literature 2
   Japanese Patent Application Publication, Tokukaihei, No. 9-252651 A (Publication Date: September 30, 1997)

JP 2008 218486 A discloses a light emitting device with the aim to provide for a high light emission efficiency and to provide for white light or light with optional chrominance. In that context, it is disclosed to use blue LED lamps and arrange nothing more than these lamps in a first section, and a red phosphor or a green phosphor in other sections such that three colors blue, red and green are emitted which mix up to provide for white light.

JP 2006 324589 A equally discloses the idea of providing a resin body on top of LED devices and include one or more phosphors that emit fluorescence having an emission different from the peak wave length of the LED elements.

### Summary of Invention

### Technical Problem

However, conventional light emitting apparatuses for plant cultivation employing red LEDs and blue LEDs have the following problems (1) and (2).
(1) Depending on a target plant, it is necessary to control a ratio between a quantity of light in a blue region and a quantity of light in a red region. In a case where the quantities of light in the blue region and the red region are controlled by changing the number of the blue LEDs or the red LEDs, the ratio deviates from a predetermined ratio when the blue LEDs and the red LEDs are used for a long time due to a difference in deterioration characteristic between the blue LEDs and the red LEDs.
(2) It is difficult to mix colors of light from the blue LEDs and the red LEDs and, accordingly, difficult to obtain mixed-color light necessary for plant cultivation. Specifically, in a case where a plurality of blue LEDs and a plurality of red LEDs are used, it is extremely difficult to realize spatially uniform mixed-color light while satisfying a predetermined light quantity ratio.

Further, in order to arrange the quantity of light from the blue LEDs not to exceed 50% of the quantity of light from the red LEDs as in Patent Literature 2, it is necessary to take the following steps (A) through (C), for example.
(A) The red LEDs are caused to emit bright light (a drive current is increased).
(B) The number of LED chips to be provided in each of the LED is increased.
(C) The number of the red LEDs is increased.

However, in a case of (A), deterioration characteristics of the blue LED chips and the red LED chips become more different and, accordingly, deviation of the light quantity ratio becomes larger when the blue LED chips and the red LED chips are used for a long time. Further, in a case where the quantities of light are electrically controlled, it is necessary to provide an electric driving circuit and the like. This results in that a configuration of a light emitting apparatus becomes complicated.

In a case of (B), each of the red LEDs becomes large in size. It therefore becomes difficult to control wide-angle directional characteristics, for example.

In a case of (C), the number of the blue LEDs is low. Therefore, even if the blue LEDs are evenly arranged or the blue LEDs are ones each having a wide-angle directional characteristic, red light and blue light are not sufficiently mixed and thus color unevenness may be likely to occur.

The present invention has been made in view of the above problems, and an object of the present invention is to provide (i) a light emitting apparatus capable of, with a simple and compact configuration, easily adjusting a ratio between a quantity of blue light and a quantity of red light, and (ii) a method of manufacturing the light emitting apparatus.

### Solution to Problem

In order to attain the above object, a light emitting apparatus of the present invention includes the features of independent claim 1.

According to the above configuration, the blue light has an optical element whose wavelength falls within a range of 380 nm to 550 nm in a visible light region (ranging of 380 nm to 800 nm). Further, the red light has an optical element whose wavelength falls within a range of 550 nm to 800 nm in the visible light region.

According to the above configuration, by adjusting a concentration of the red phosphor in the resin in the first light emitting section, it is possible to adjust quantities of blue light and red light. This allows an improvement in mixture of blue light and red light. Further, the first light emitting section is capable of emitting both red light and blue light. It is therefore possible to easily adjust, with a simple and compact configuration, a ratio between a quantity of blue light and a quantity of red light.

Moreover, the second light emitting section, made up of only the blue LED chip, is provided so as to be adjacent to the first light emitting section. This makes it possible to use (i) the first light emitting section mainly for emitting red light and (ii) the second light emitting section mainly for emitting blue light, and possible to independently control the first light emitting section and the second light emitting section. It is therefore possible to easily adjust quantities of blue light and red light. As a result, regarding mixed-color light generated by the first light emitting section and the second light emitting section, it is possible to freely change a ratio between blue light and red light, and accordingly possible to improve mixture of red light and blue light.

Further, the first light emitting section and the second light emitting section are each made up of only the blue LED chip identical in deterioration characteristic. Accordingly, the blue LED chips similarly deteriorate when the blue LED chips are used for a long time. Therefore, such a problem does not occur that, as in conventional techniques, deviation of the light quantity ratio becomes larger when the blue LED chips are used for a long time.

Further, the red phosphor is used as a light source of red light, instead of a red LED chip, which is low in luminous efficiency. This allows a reduction in costs, and allows the light emitting apparatus of the present invention to have considerably improved life, as compared with a light emitting apparatus using a red LED chip. Further, use of no red LED chip, which is poor in temperature characteristic, allows an improvement in temperature characteristic.

Further, the red phosphor is dispersed in an identical region in which the blue LED chip, which has good luminous efficiency, is provided. It is therefore possible to provide a light emitting apparatus which emits further improved mixed-color light and which has much smaller installation areas for light emitting sections.

A method for manufacturing a light emitting apparatus of the present invention includes the steps indicated in independent claim 9.

According to the above configuration, it is possible to form the mixed light emitting section in which the red phosphor is dispersed, and therefore possible to manufacture a light emitting apparatus capable of easily adjusting red and blue optical elements and accordingly emitting further improved mixed-color light.

Further, the light emitting apparatus is configured to emit red light with the use of the blue LED chip which has good luminous efficiency. Therefore, it is possible to (i) efficiently emit blue light and red light, (ii) prevent an increase in installation area of the light emitting sections, and (iii) suppress manufacturing costs.

### Advantageous Effects of Invention

According to the present invention, it is possible to provide a light emitting apparatus including: a substrate; and a plurality of light emitting sections provided on the substrate, the plurality of light emitting sections including at least a first light emitting section and a second light emitting section provided so as to be adjacent to each other, the first light emitting section being made up of (i) at least one first blue LED chip which emits blue light and (ii) a resin layer which covers the at least one first blue LED chip and in which a red phosphor is dispersed that emits red light upon receipt of excitation light from the at least one first blue LED chip, the second light emitting section being made up of at least one second blue LED chip which emits blue light. Furthermore, according to the present invention, it is possible to provide a method of manufacturing a light emitting apparatus. According to the light emitting apparatus of the present invention, it is possible to independently control (i) the first light emitting section so as to emit blue light and red light and (ii) the second light emitting section so as to emit blue light. Further, it is possible to easily adjust a ratio between a quantity of blue light and a quantity of red light although the light emitting apparatus has only a simple configuration and its LEDs occupy a small area. Moreover, according to the light emitting apparatus of the present invention, the plurality of light emitting sections are formed, for example, so as to be convoluted. It is therefore possible to obtain further improved mixed-color light.

### Brief Description of Drawings

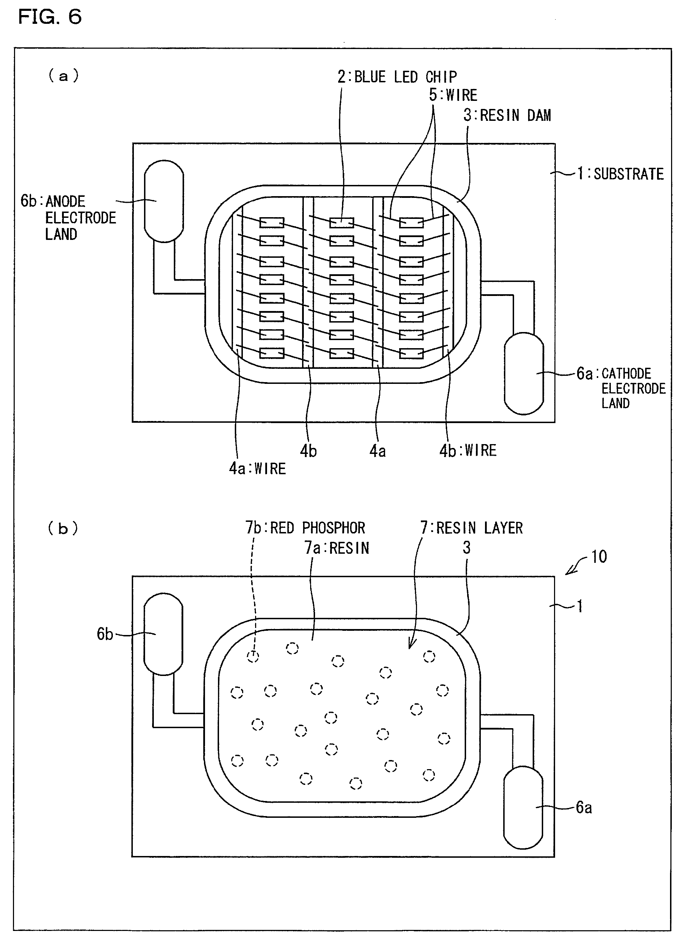

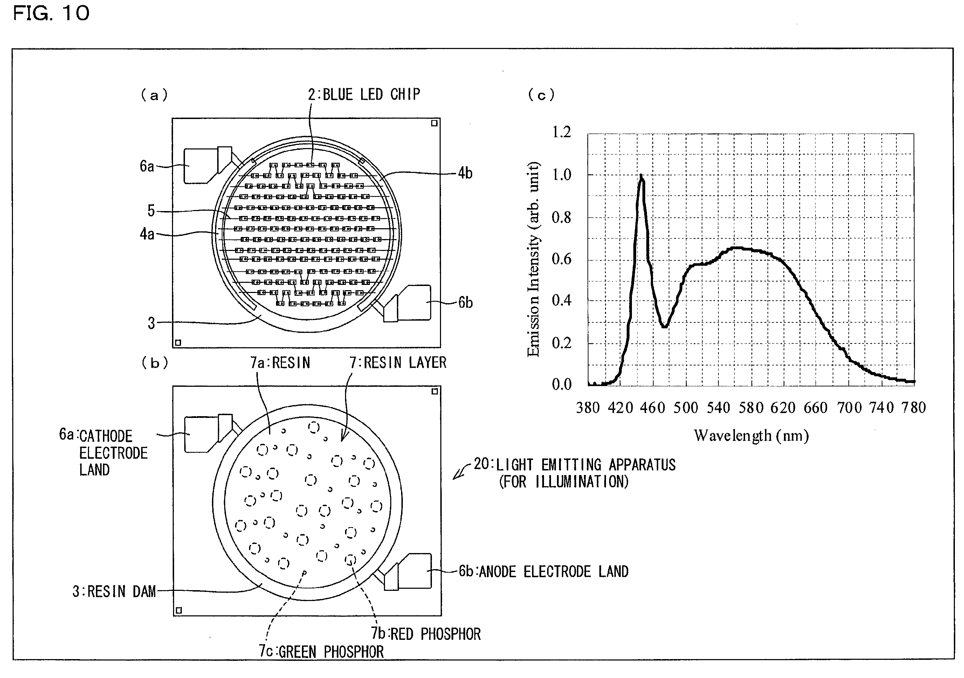

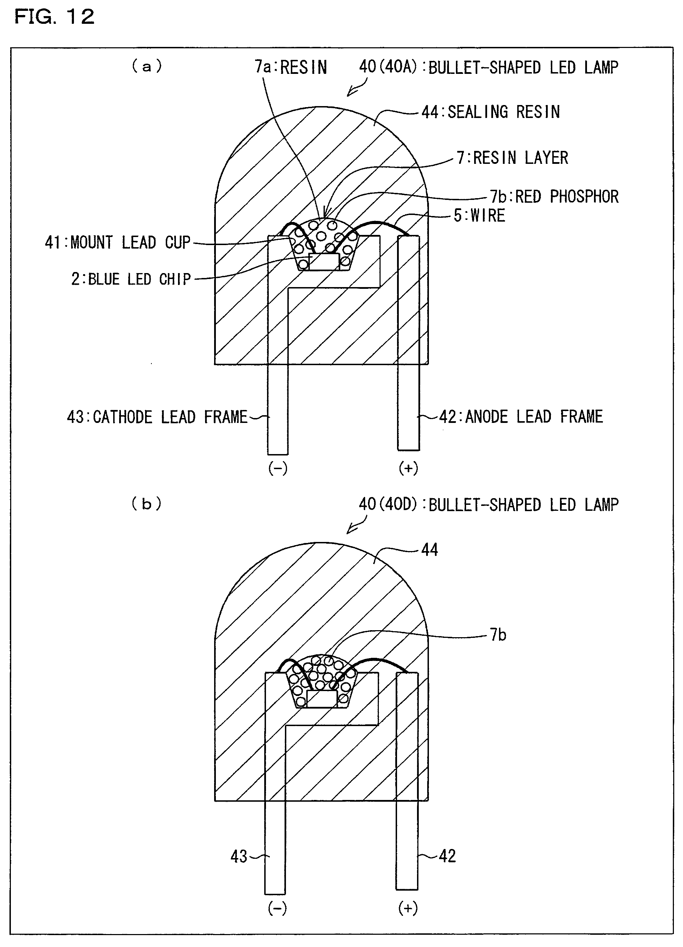

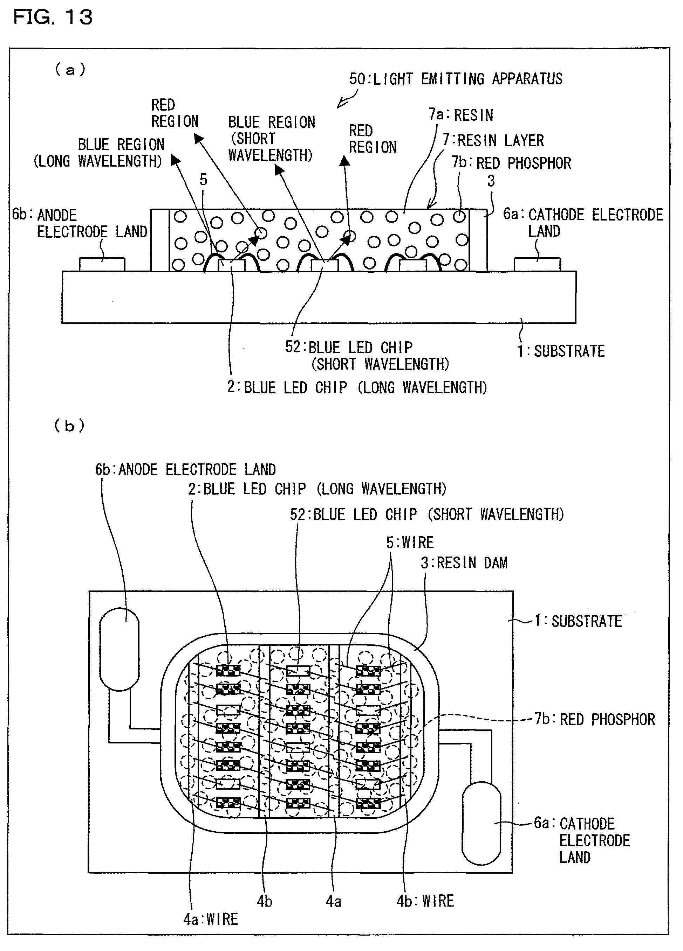

Fig. 1 is a plane view illustrating an example configuration of a light emitting surface of a spiral-type light emitting apparatus in accordance with Embodiment 1 of the present invention.
Fig. 2 is a plane view illustrating an example configuration of a light emitting surface of a horizontally-striped-type light emitting apparatus in accordance with Embodiment 2 of the present invention.
Fig. 3 is a plane view illustrating an example configuration of a light emitting surface of a cross-type light emitting apparatus in accordance with Embodiment 3 of the present invention.
Fig. 4 is a plane view illustrating an example configuration of a light emitting surface of a double circle-type light emitting apparatus in accordance with Embodiment 4 of the present invention.
Fig. 5 is cross-sectional views each illustrating an example configuration of a substrate-type light emitting apparatus using a premised technique of the present invention. (a) of Fig. 5 is a cross-sectional view illustrating red phosphors. (b) of Fig. 5 is a cross-sectional view illustrating an aspect of the substrate-type light emitting apparatus using the premised technique.
(a) of Fig. 6 is a plane view illustrating a configuration of the light emitting apparatus using the premised technique in which apparatus a resin layer has not been formed. (b) of Fig. 6 is a plane view illustrating a configuration of the light emitting apparatus using the premised technique in which apparatus the resin layer has been formed.

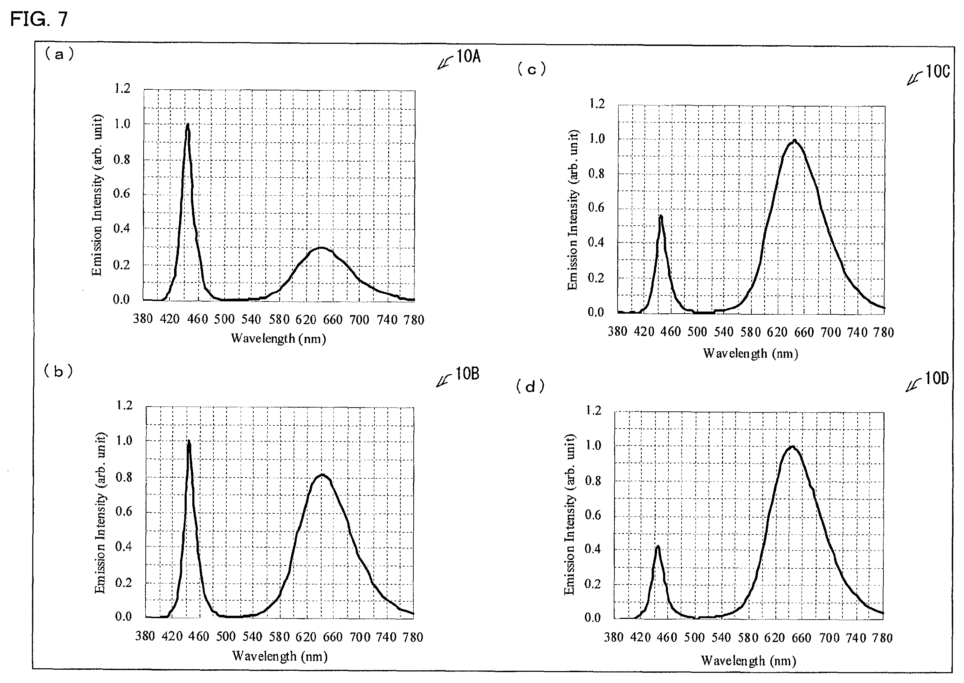

Fig. 7 is graphs each illustrating an emission spectrum according to a compound ratio between a resin and the red phosphors of the light emitting apparatus using the premised technique. (a) of Fig. 7 is a graph observed in a case where the compound ratio between the resin and the red phosphors is 1 : 0.05. (b) of Fig. 7 is a graph observed in a case where the compound ratio between the resin and the red phosphors is 1 : 0.10. (c) of Fig. 7 is a graph observed in a case where the compound ratio between the resin and the red phosphors is 1 : 0.15. (d) of Fig. 7 is a graph observed in a case where the compound ratio between the resin and the red phosphors is 1 : 0.20.

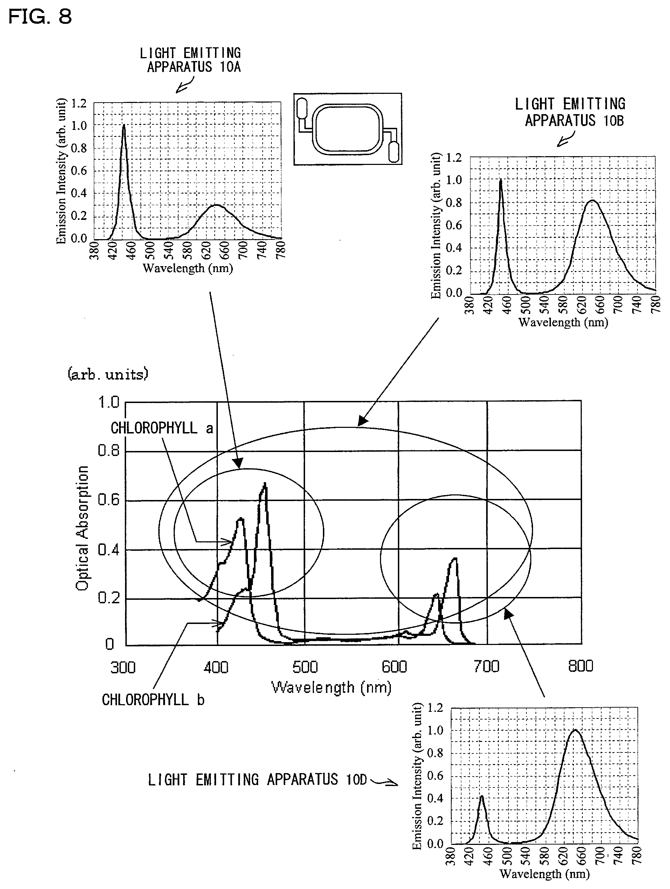

Fig. 8 is a view illustrating (i) absorption spectra of chlorophyll and (ii) example applications of the light emitting apparatus using the premised technique.

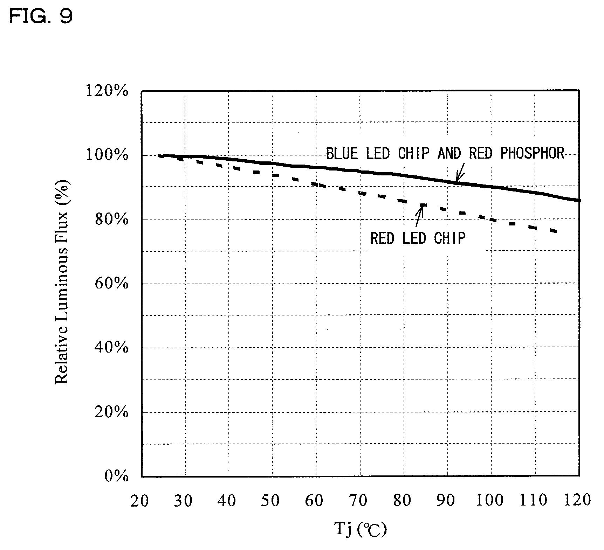

Fig. 9 is a graph illustrating a temperature characteristic of the light emitting apparatus using the premised technique in comparison with and a temperature characteristic of a conventional light emitting apparatus.
(a) and (b) of Fig. 10 are each a plane view illustrating a configuration of a light emitting apparatus for illumination using the premised technique. (c) of Fig. 10 is a graph illustrating an emission spectrum of light from the light emitting apparatus for illumination using the premised technique.

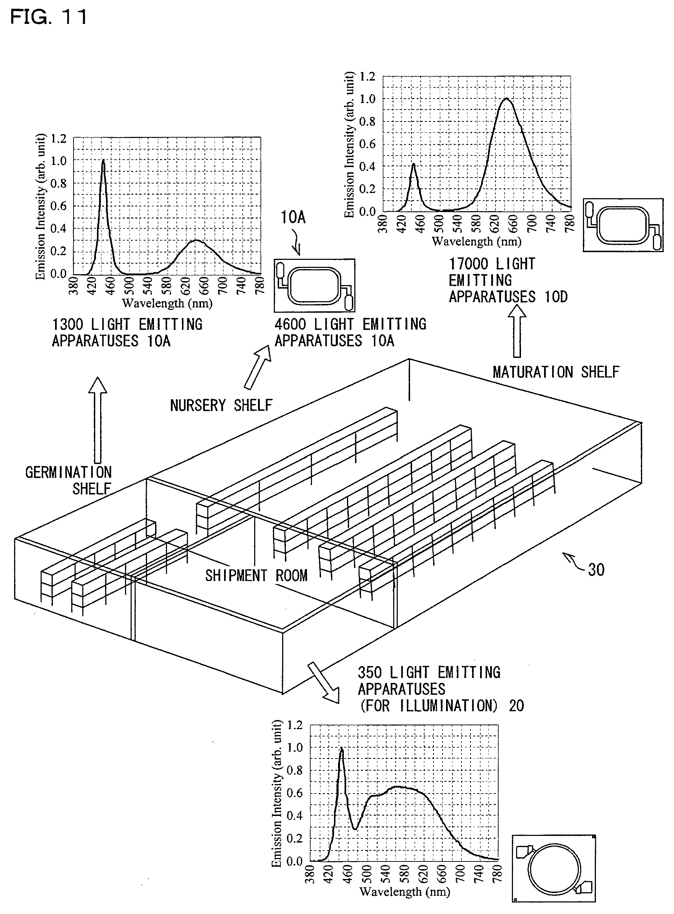

Fig. 11 is an explanatory diagram illustrating an example application, to a plant factory, of the light emitting apparatus using the premised technique.
(a) of Fig. 12 is a cross-sectional view illustrating a configuration of a bullet-shaped LED lamp of a comparative technique which bullet-shaped LED lamp is arranged such that a compound ratio between a resin and red phosphors is 1 : 0.05. (b) of Fig. 12 is a cross-sectional view illustrating a configuration of the bullet-shaped LED lamp of a comparative technique which bullet-shaped LED lamp is arranged such that the compound ratio between the resin and the red phosphors is 1 : 0.20.
(a) of Fig. 13 is a cross-sectional view illustrating a configuration of a blue-complex-type light emitting apparatus using another aspect of the premised technique. (b) of Fig. 13 is a plane view illustrating a configuration of the blue-complex-type light emitting apparatus in which a resin layer has not been formed.
Fig. 14 is plane views each illustrating an example configuration of a light emitting surface of a conventional light emitting apparatus. (a) of Fig. 14 is a plane view illustrating a light emitting surface of a light emitting apparatus of Patent Literature 1. (b) of Fig. 14 is a plane view illustrating a light emitting surface of a light emitting apparatus of Patent Literature 2.

### Description of Embodiments

### [Embodiment 1]

### (Basic configuration of light emitting apparatus)

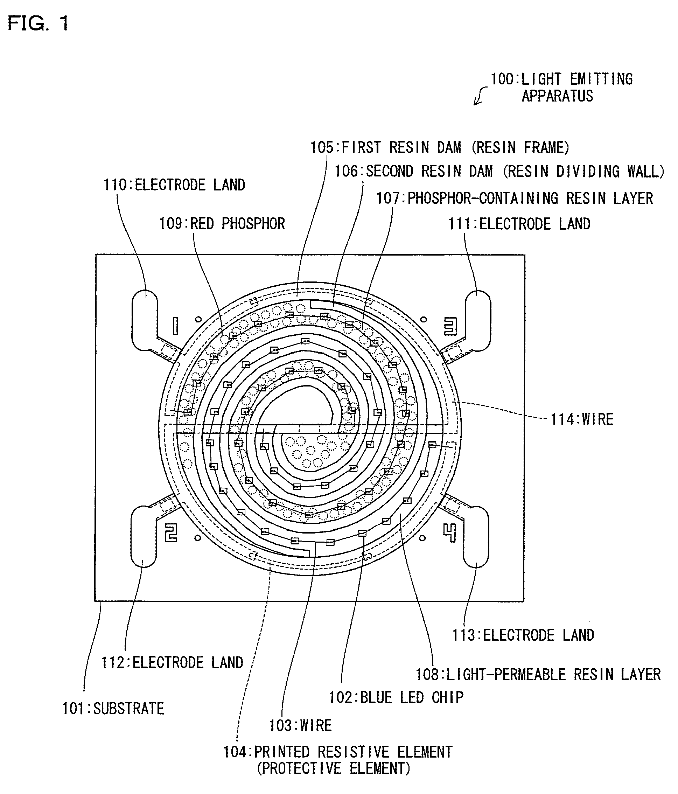

Fig. 1 is a plane view illustrating an example configuration of a light emitting apparatus 100 in accordance with Embodiment 1.

As illustrated in Fig. 1, the light emitting apparatus 100 includes a substrate 101, blue LED chips 102 (light emitting elements), printed resistive elements 104 (protective elements), a first resin dam 105 (resin frame), a second resin dam 106 (resin dividing wall), a phosphor-containing resin layer 107, a light-permeable resin layer 108, and red phosphors 109.

The substrate 101 is a substrate made of ceramic. The substrate 101 has a rectangular shape when viewed from above. The blue LED chips 102, the printed resistive elements 104, the first resin dam 105, the second resin dam 106, the phosphor-containing resin layer 107, the light-permeable resin layer 108, and the red phosphors 109 are provided on one surface of the substrate 101 (hereinafter, referred to as an upper surface). Electrode lands 110 through 113 for external connection are further provided on the upper surface of the substrate 101.

The electrode lands 110 and 112 each function as an anode electrode, whereas the electrode lands 111 and 113 each function as a cathode electrode. The electrode lands 110 through 113 are provided near respective corners of the upper surface of the substrate 101 and outside a region enclosed by the first resin dam 105. A surface of each of the electrode lands 110 through 113 is exposed. Each of the electrode lands 110 through 113 can be therefore connected to an external terminal, via such a surface.

Wires are provided which are electrically connected to the respective electrode lands 110 through 113. According to Embodiment 1, each of the wires is a printed wire. Note, however, that the wires are not limited to such. Each of the wires, electrically connected to a corresponding one of the electrode lands 110 and 113, is provided in an area where the first resin dam 105 is provided while being embedded in the first resin dam 105. Each of the wires, electrically connected to a corresponding one of the electrode lands 111 and 112, (i) is provided in another area where the first resin dam 105 is provided while being embedded in the first resin dam 105 and (ii) extends on the substrate 101 from one end of the each of the wires toward but short of the center of the substrate 101. Each of the wires, electrically connected to a corresponding one of the electrode lands 111 and 112 is therefore not connected to other wire(s).

The blue LED chips 102 are electrically connected to each other and to the wires, via wires 103. Specifically, a wire, electrically connected to the electrode land 113, is electrically connected to a blue LED chip 102 at one end of a series of blue LED chips 102 via a wire 103, and a wire, electrically connected to the electrode land 112, is electrically connected to a blue LED chip 102 at the other end of the series of the blue LED chips 102 via a wire 103. This causes the series of the blue LED chips 102 to be electrically connected between the electrode lands 113 and 112, via the wires 103.

This ultimately allows each of the series of the blue LED chips 102 to emit light by electrically connecting them to the electrode lands 113 and 112, via the wires 103. Similarly, the other series of blue LED chips 102 are electrically connected to the electrode lands 111 and 110, via the other wires 103. This allows each of the series of the blue LED chips 102 to emit light.

The blue LED chips 102 are provided at regular intervals so as to have a double-spiral shape. Note that the double-spiral shape is not limited to any particular one. However, it is preferable that the double-spiral shape has a uniformly helical shape, i.e., a so-called Archimedean helical shape. Specifically, it is preferable that a distance between corresponding two points on circumferences of two spirals, i.e., a distance between corresponding two points on double-spiral lines, is constant.

According to the Embodiment 1, a series of blue LED chips 102 are provided so as to have double-spiral having one and a half rounds. Furthermore, according to Embodiment 1, 26 blue LED chips 102 are provided at regular intervals on each of the double-spiral lines. Note that a material of each of the wires 103 is not limited to any particular one, provide that the material is metal, alloy, or other material having high electric conductivity. Examples of the material of each of the wires 103 include gold (Au).

The first resin dam 105 and the second resin dam 106 each define a region in which the phosphor-containing resin layer 107 is formed and a region in which the light-permeable resin layer 108 is formed. That is, the first resin dam 105 and the second resin dam 106 each function as a dam (blocking member) which prevents a resin from leaking during forming the phosphor-containing resin layer 107 and the light-permeable resin layer 108.

The first resin dam 105 is provided so as to enclose a predetermined region in which the blue LED chips 102 are provided (a region in which a plurality of light emitting sections are provided). The first resin dam 105 thus has a precisely circular (ring) shape when viewed from above.

The second resin dam 106 is provided so as to divide the region, enclosed by the first resin dam 105, into (i) the region in which the phosphor-containing resin layer 107 is formed and (ii) the region in which the light-permeable resin layer 108 is formed. This causes the second resin dam 106 to be formed in a double-spiral shape, so that the second resin dam 106 extends from the first resin dam 105 toward a center of a mounting region as if double-spiral lines were combined in the mounting region. It is preferable that the double-spiral lines have a uniformly helical shape and a distance between the double-spiral lines is constant.

With the configuration, two types of light emitting sections (later described), each of which is a region from which the light is emitted by the light emitting apparatus of Embodiment 1, are not formed collectively but formed so as to be convoluted. This causes equivalent light distribution characteristics to be convoluted and close to each other. It is therefore possible to easily obtain good mixed-color light, in a case where the light emitting sections are simultaneously turned on. Furthermore, since the light emitting sections are close to each other, each of the light emitting sections is equally affected by heat. Accordingly, brightness and a color tone of generated light are less affected by heat and/or a change with the times. It is further possible to reduce big changes in peak wavelength and color rendering property.

According to Embodiment 1, the second resin dam 106 is in contact with, at two areas, the first resin dam 105 having a ring shape. The first resin dam 105 and the second resin dam 106 are formed symmetrically with respect to a point.

Each of the first resin dam 105 and the second resin dam 106 is made of resin, having light reflectivity or a light-blocking property, such as white silicone resin. In particular, the white silicone resin is preferably arranged such that a light-permeable silicone resin serving as a base material contains titanium oxide (TiO₂) as a light diffusion filler. This causes a less deterioration in resin and accordingly causes an increase in reliability, as compared with a resin such as an epoxy resin.

Note that a compound which can be employed as the light diffusion filler is not limited to titanium oxide (TiO₂). Alternatively, for example, silica (SiO₂), alumina (Al₂O₃), calcium carbonate (CaCO₃), barium sulphate (BaSO₄), or aluminum hydroxide (Al(OH)₃) can be employed as such a compound.

The phosphor-containing resin layer 107 is a sealing resin layer made of resin which contains dispersed particulate red phosphors 109. The phosphor-containing resin layer 107 is filled in one of the two regions enclosed by the first resin dam 105 and the second resin dam 106, and is formed so as to embed therein the blue LED chips 102 and the wires 103 which are provided in the one of the two regions. That is, the phosphor-containing resin layer 107 is formed so as to wholly seal the blue LED chips 102 and so as to draw a spiral when viewed from above.

The light emitting apparatus 100 is configured such that (i) a first light emitting section constituted by the blue LED chips 102 and the phosphor-containing resin layer 107 and (ii) a second light emitting section constituted by the blue LED chips 102 and the light-permeable resin layer 108 are formed in the respective two regions each having a spiral shape and being enclosed by the first resin dam 105 and the second resin dam 106.

The light-permeable resin layer 108 is a sealing resin made of resin. The light-permeable resin layer 108 is filled in the other of the two regions enclosed by the first resin dam 105 and the second resin dam 106, in which region no phosphor-containing resin layer 107 is formed. The light-permeable resin layer 108 is formed so as to embed therein the blue LED chips 102 and the wires 103 which are provided in the other of the two regions. That is, the light-permeable resin layer 108 is formed so as to wholly seal the blue LED chips 102 and so as to draw a spiral when viewed from above.

According to the light emitting apparatus 100, the phosphor-containing resin layer 107 and the light-permeable resin layer 108 are thus provided in the respective regions divided by the second resin dam 106. As such, light emitting surfaces are close to each other. Note that a part (in a spiral shape) dividing the light emitting surfaces are substantially provided uniformly ranging over the whole gamut of the region inside the first resin dam 105.

With the above configuration, the light emitting sections are not formed collectively, but are formed so as to be convoluted. It is therefore possible to obtain further improved mixed-color light.

Note that, according to the light emitting apparatus 100, the number of the light emitting sections is not limited to two. Alternatively, the light emitting apparatus 100 can include three or more light emitting sections. In this case, it is only necessary to change, as needed, a shape of the second resin dam 106 in accordance with the number of the light emitting sections. In such a case, it is desirable to provide (i) electrode lands, each functioning as a cathode electrode, whose number is identical to that of the light emitting sections and (ii) electrode lands, each functioning as an anode electrode, whose number is identical to that of the light emitting sections. This makes it possible to individually drive the light emitting sections.

Specifically, in a case where, as viewed from a direction perpendicular to the upper surface of the substrate 101, a center of a region on the upper surface in which region three or more light emitting sections are provided is regarded as a reference point, each shape of the three or more light emitting sections is only necessary to be set so that, as viewed in a cross section perpendicular to and passing through the reference point, a resin layer of each of the three or more light emitting sections is provided in a plurality of areas so as to be adjacent to a resin layer of each of the others of the three or more light emitting sections.

Note also that, according to the light emitting apparatus 100, it is possible to independently control (i) light emission from the phosphor-containing resin layer 107 and (ii) light emission from the light-permeable resin layer 108, by connecting the electrode lands 110 through 113 to respective external terminals and then supplying electric power to each of the electrode lands 110 through 113.

Specifically, in a case where (i) the phosphor-containing resin layer 107 containing the red phosphors and the blue LED chips embedded in the phosphor-containing resin layer 107 are regarded as a first light emitting section and (i) the light-permeable resin layer 108 and the blue LED chips embedded in the light-permeable resin layer 108 is regarded as a second light emitting section, it is possible to independently drive (i) the first light emitting section by use of the electrode lands 110 and 111 electrically connected to the blue LED chips 102 of the first light emitting section and (ii) the second light emitting section by use of the electrode lands 112 and 113 electrically connected to the blue LED chips 102 of the second light emitting section.

### (Blue LED Chips)

Next, the following description will simply discuss photosynthetic living things before providing a light emitting apparatus for cultivation and culture. Subsequently, the blue LED chips will be described. Some living things absorb and use light energy as their energy. Most of such some living things are known to have a photosynthetic pigment compound such as chlorophyll, which plays a main role in photosynthesis.

It is known that various living things, including not only plants but also bacteria, have chlorophyll. The living things having chlorophyll absorb light energy via chlorophyll, and grow or multiply by use of the light energy. It is thus possible to provide a light emitting apparatus which can efficiently carry out cultivation and culture by irradiating the living things having chlorophyll with light which the living things can efficiently absorb via chlorophyll.

According to the present embodiment, the blue LED chips are employed. This is because chlorophyll has an absorption peak in a blue region.

Chlorophyll also absorbs red light. Note, however, that (i), in general, a red LED chip easily deteriorates as compared with a blue LED chip and (ii) the red LED chip is low in luminous efficiency. According to Embodiment 1, the blue LED chips are therefore employed and light, emitted from the red phosphors, are used as red light.

Specifically, chlorophyll has optical absorption peaks in (i) the blue region referred to as a B band (Soret band) (wavelength within a range of 400 nm to 480 nm) and (ii) a red region referred to as a Q band. Chlorophyll a and chlorophyll b are each known as a kind of chlorophyll, which (i) are often seen in, for example, plants and some of algae and (ii) have respective different optical absorption characteristics. Specifically, chlorophyll a has an optical absorption peak falling within a wavelength range of 430 nm to 440 nm in the blue region, whereas chlorophyll b has an optical absorption peak falling within a wavelength range of 450 nm to 460 nm in the blue region.

Note that, in addition to chlorophyll a and chlorophyll b, various types of chlorophyll are known. Example of such chlorophyll include chlorophyll c₁, chlorophyll c₂, chlorophyll d, chlorophyll f, bacterio-chlorophyll a, bacterio-chlorophyll b, bacterio-chlorophyll c, bacterio-chlorophyll d, bacterio-chlorophyll e, bacterio-chlorophyll f, and bacterio-chlorophyll g, each of which is known to have an absorption peak in the blue region. Note also that, other than chlorophyll, carotenoid and the like are known as the photosynthetic pigment compound which absorbs light energy. It is also known that carotenoid has an optical absorption peak in the blue region.

In view of the circumstances, each of the blue LED chips 102 is preferably a blue LED chip which emits light having an emission peak wavelength within a range of 400 nm to 480 nm. Particularly, the emission peak wavelength falls within a range of 430 nm to 460 nm.

By employing such a blue LED chip, it is possible to more efficiently provide light that is suitable to cultivate or culture the living things. Especially, since chlorophyll of a plant has the optical absorption peak near a wavelength of 450 nm in the blue region, it is possible to provide a light emitting apparatus suitable to cultivate a plant or culture specific algae.

Note that according to the invention the blue LED chips 102 which are covered by the phosphor-containing resin layer 107 are be different in emission peak wavelength from the blue LED chips 102 which are covered by the light-permeable resin layer 108.

For example, a configuration can be employed in which (i) the blue LED chips 102 each of which emits light having an emission peak wavelength which falls within a range of 430 nm to 440 nm (blue LED chips 102 of type I) are provided in the phosphor-containing resin layer 107 of the first light emitting section and (ii) the blue LED chips 102 each of which emits light having an emission peak wavelength which falls within a range of 450 nm to 460 nm (blue LED chips 102 of type II) are provided in the light-permeable resin layer 108 of the second light emitting section.

With the configuration, it is possible to control, in each of (i) the region covered by the phosphor-containing resin layer 107 (the first light emitting section) and (ii) the region covered by the light-permeable resin layer 108 (the second light emitting section), an electric current flowing through the blue LED chips 102 so as to control their light emissions. It is therefore possible to control, as appropriate, light emission so as to have a quantity suitable for a specific target plant or algae which have various ratios between (i) chlorophyll a (whose optical absorption peak falls within a wavelength range of 430 nm to 440 nm) and (ii) chlorophyll b (whose optical absorption peak falls within a wavelength range of 450 nm to 460 nm). It is therefore possible to provide a light emitting apparatus which emits a more suitable optical element.

Note that the blue LED chips 102 of type I and the blue LED chips 102 of type II can be mixed in a same region covered by the phosphor-containing region layer 107 and the region covered by the light-permeable resin layer 108.

Specifically, blue LED chips 102 of type I and blue LED chips 102 of type II are arranged so that, for example, (i) two blue LED chips of type I are located between respective two blue LED chips 102 of type II, (ii) three blue LED chips of type I are located between respective two blue LED chips 102 of type II, or (ii) four blue LED chips of type I are located between respective two blue LED chips 102 of type II.

By thus arranging the blue LED chips 102 of type I and type II in accordance with a ratio between (i) an absorption spectrum of chlorophyll a (whose optical absorption peak is within a wavelength range of 430 nm to 440 nm) and (ii) an absorption spectrum of chlorophyll b (whose optical absorption peak is within a wavelength range of 450 nm to 460 nm) of a specific target plant or algae, it is possible to provide a light emitting apparatus which emits a suitable optical element having a light emission suitable for the specific target plant or algae having a certain ratio between chlorophyll a and chlorophyll b.

Note that the light emitting apparatus 100 includes the blue LED chips 102 which have identical shapes. However, Embodiment 1 is not limited to such. Alternatively, the light emitting apparatus 100 can include the blue LED chips 102 which have respective different shapes and/or size. For example, a shape of an upper surface of each of the blue LED chips 102 is not limited to rectangle, but can be square. This allows an increase in degree of freedom of how the blue LED chips 102 are to be arranged.

Note that publicly available LED chips can be employed as the blue LED chips 102 of Embodiment 1.

### (Red Phosphors)

As has been described, chlorophyll has the optical absorption peak in the red region referred to as a Q band. Specifically, chlorophyll a has an optical absorption peak within a range of 650 nm to 660 nm in the red region, whereas chlorophyll b has an optical absorption peak within a range of 620 nm to 630 nm in the red region.

In view of the circumstances, according to Embodiment 1, the red phosphors 109 are dispersed in the phosphor-containing resin layer 107 in which the blue LED chips 102 are provided so that red right is simultaneously emitted by use of light energy generated by the blue LED chips 102 covered by the phosphor-containing resin layer 107. That is, the red phosphors 109 are phosphors each of which emits red light by being excited by optical elements generated from the LED chips 102.

Therefore, in a case where the light emitting apparatus for cultivation and culture of Embodiment 1 is used to cultivate a plant, it is preferable to employ (Sr,Ca)AlSiN₃:Eu phosphors and/or CaAlSiN₃:Eu phosphors each of which is a red phosphor having an emission peak wavelength close to the optical absorption peak wavelength of chlorophyll a or chlorophyll b.

Note that a CaAlSiN₃:Eu phosphor is a nitride red phosphor in which europium (Eu) is an activator. The CaAlSiN₃:Eu phosphor is one of phosphors whose temperature characteristics are stable and whose luminous efficiencies are high.

Note also that each of the (Sr,Ca)AlSiN₃:Eu phosphors is a phosphor obtained from the CaAlSiN₃:Eu phosphors by replacing part of Ca with Sr so that the emission peak wavelength is shifted toward a shorter wavelength. As with the CaAlSiN₃:Eu phosphors, each of the (Sr,Ca)AlSiN₃:Eu phosphors has high temperature characteristic and high luminous efficiency.

Particularly, in a case where the light emitting apparatus of Embodiment 1 is used to cultivate a plant or culture algae containing a large amount of chlorophyll a, it is preferable to employ the CaAlSiN₃:Eu phosphors. This is because an emission peak of each of the CaAlSiN₃:Eu phosphors, which peak falls within a wavelength range of 620 nm to 660 nm, matches the optical absorption peak of chlorophyll a, which peak falls within a wavelength range of 650 nm to 660 nm in the red region. It is thus possible to provide a light emitting apparatus suitable to cultivate or culture a living thing containing a large amount of chlorophyll a.

On the other hand, in a case where the light emitting apparatus of Embodiment 1 is used to cultivate a plant or culture algae including a large amount of chlorophyll b, it is preferable to employ the (Sr,Ca)AlSiN₃:Eu phosphors. This is because an emission peak of each of the (Sr,Ca)AlSiN₃:Eu phosphors, which peak falls within a wavelength range of 620 nm to 630 nm, matches the optical absorption peak of chlorophyll b, which peak falls within a wavelength range of 620 nm to 630 nm in the red region. It is thus possible to provide a light emitting apparatus suitable to cultivate or culture a living thing containing a large amount of chlorophyll b.

Note that the red phosphors 109 are not limited to the red phosphors. Alternatively, it is possible to employ, for example, 3.5MgO·0.5MgF₂·GeO₂:Mn, La₂O₂S:Eu, Y₂O₂S:Eu, LiEuW₂O₈, (Y, Gd, Eu)₂O₃, (Y, Gd, Eu)BO₃, YVO₄:Eu, and/or CaS:Eu, Ce, K, each of which is a red phosphor in a particulate state.

Furthermore, plural kinds of red phosphors 109 can be employed by mixture at any specific ratio. It is therefore possible to provide a light emitting apparatus suitable for various types of living things each having chlorophyll a, chlorophyll b, and another chlorophyll at a specific ratio.

Further, the light emitting apparatus of the Embodiment 1 can be used to culture specific bacteria having bacterio-chlorophyll which is a kind of chlorophyll. It is known that bacterio-chlorophyll has an optical absorption peak whose wavelength is not less than 800 nm that is longer than that of the optical absorption peak in the red region of chlorophyll a or chlorophyll b.

In this case, red phosphors are employed whose emission peak is longer than that of red phosphor. That is, it is also possible to provide a light emitting apparatus more suitable to culture specific bacteria having bacterio-chlorophyll, by (i) selecting red phosphors whose emission peak matches the optical absorption peak of bacterio-chlorophyll and (ii) dispersing and introducing the red phosphors into the phosphor-containing resin layer.

According to the Embodiment 1, a compound ratio (weight ratio), in the phosphor-containing resin layer 107, between the resin and the red phosphors 109 falls within a ratio of 1 : 0.05 to 1 : 0.40. As a result, it is possible to provide a light emitting apparatus suitable to germinate, nursery, and maturate a plant, or to culture specific algae.

Particularly, in a case where the light emitting apparatus of Embodiment 1 is used to cultivate a plant, the compound ratio (weight ratio), in the phosphor-containing resin layer 107, between the resin and the red phosphors 109 preferably falls within a ratio of 1 : 0.30 to 1 : 0.40.

With the configuration, at a maturation stage at which a plant grows to have a leaf and becomes active in photosynthesis, it is possible to provide a light emitting apparatus which cultivates a plant by easily emitting light having both blue and red optical elements.

### (Photosynthetic Photon Flux)

With the configuration, the first light emitting section emits blue light and red light due to "blue LED chips + red phosphors". The second light emitting section emits blue light due to "blue LED chips".

It is possible to individually drive the first and second light emitting sections. This makes it possible to independently turn on the first and second light emitting sections. It is also possible to independently turn on the first and second light emitting sections, by controlling a turn-on condition (emission intensity) on which each of the first and second light emitting sections is turned on. By controlling a turn-on condition (emission intensity) on which each of the first and second light emitting sections is turned on, it is further possible to easily control a ratio between (i) a photosynthetic photon flux in the blue region ranging from 400 nm to 480 nm and (ii) a photosynthetic photon flux in the red region ranging from 620 nm to 700 nm so as to fall within a ratio of 1 : 1.3 to 1 : 10.

It is therefore possible to provide a light emitting apparatus suitable for germination, nursery, and maturation of a plant, and/or for culture of specific algae or bacteria.

Particularly, in a case where the light emitting apparatus of the preset invention is used to cultivate a plant, the ratio between (i) the photosynthetic photon flux in the blue region ranging from 400 nm to 480 nm and (ii) a photosynthetic photon flux in the red region ranging from 620 nm to 700 nm preferably falls within a ratio of 1 : 7.5 to 1 : 10. With this configuration, it is possible to provide a light emitting apparatus more suitable to cultivate a plant.

In a case where the light emitting apparatus of the present invention is used to germinate or nursery a plant, the ratio between (i) the photosynthetic photon flux in the blue region ranging from 400 nm to 480 nm and (ii) the photosynthetic photon flux in the red region ranging from 620 nm to 700 nm preferably falls within a ratio of 1 : 1.3 to 1 : 3.5. With this configuration, it is possible to provide a light emitting apparatus suitable to germinate and nursery a plant.

### (Automatic emission control section)

As has been described, chlorophyll, which plays a main role in photosynthesis of a plant, has clear optical absorption peaks in the blue and red regions. That is, at the maturation stage at which a plant grows to have a leaf and becomes active in photosynthesis, it is useful in growing a plant to have both (i) an optical element having an emission peak in the blue region and (ii) an optical element having an emission peak in the red region.

Meanwhile, light in the blue region also affects light reaction of plants called high-energy reaction system and is, accordingly, essential for healthy morphogenesis of specific plants. Therefore, at a germination and nursery stage, the optical element in the blue region increases in importance.

In view of the circumstances, a method of cultivating a specific plant can be employed in which, at a maturation stage at which a specific plant grows to have a leaf and becomes active in photosynthesis, (i) the emission intensity of the blue LED chips of the first light emitting section (which emits blue light and red light) is increased and (ii) the emission intensity of the blue LED chips of the second light emitting section (which emits blue light) is reduced ,as compared with a germination and nursery stage. It is therefore possible to provide, with the use of a single light emitting apparatus, optical elements which are most suitable for (i) the germination and nursery stage and (ii) the maturation stage at which a plant grows to have a leaf and becomes active in photosynthesis.

Furthermore, in a case where the light emitting apparatus of Embodiment 1 is applied to a plant factory, it is possible to control, with the use of a single light emitting apparatus, a light quantity ratio in accordance with each stage without increasing an area required for germination, nursery, and maturation and/or an area in which the light emitting apparatus is provided.

In this case, it is preferable to include an emission control means for automatically (i) increasing the emission intensity of the first light emitting section or (ii) reducing the emission intensity of the second light emitting section in accordance with time information on a target plant, which time information is (i) checked in advance at each of the germination stage, the nursery stage, and the maturation stage at which the plant grows to have a leaf and becomes active in photosynthesis and (ii) entered in the emission controlling means in advance. The emission control means is, for example, a sequencer.

With this configuration, it is possible to automatically provide, with the use of a single light emitting apparatus and without an operation by a human, optical elements which are most suitable for a specific plant at each of the germination stage, the nursery stage, and the maturation stage at which a plant grows to have a leaf and becomes active in photosynthesis.

Note that emission control carried out by the emission control means is not limited to (i) the germination and nursery stage and (ii) the maturation stage at which a plant grows to have a leaf and becomes active in photosynthesis. The emission control means can control the emission intensity in accordance with subdivided growths of a plant.

### (Substrate)

Note that a shape of the upper surface of the substrate 101 is not limited to rectangle. The shape of the upper surface of the substrate can be, for example, polygonal, square, or circular. According to the light emitting apparatus 100 of Embodiment 1, a substrate made of ceramics is employed as the substrate 101. However, the substrate 101 is not limited to the substrate made of ceramics. Instead, a metal core substrate can be, for example, employed which is obtained by forming an insulating layer on a surface of a metal substrate.

In this case, (i) the insulating layer is provided only in areas in which the printed resistive elements 104, the wires, and the electrode lands 110 through 113 are provided and (ii) the blue LED chips 102 are directly provided on the metal substrate.

The printed resistive elements 104 are preferably covered by the first resin dam 105 if at all possible. However, Embodiment 1 is not limited to such a configuration. Further, a Zener diode with which a voltage is controlled can be provided. Also in this case, the Zener diode is preferably covered by the first resin dam 105 if at all possible. However, Embodiment 1 is not limited to such a configuration.

Note that the light emitting apparatus 100 is not always necessary to include the printed resistive elements 104. A size (resistance) of each of the printed resistive elements 104 and where a circuit is to be provided can be determined in accordance with (i) the number of the blue LED chips 102 to be provided and (ii) a usage environment (e.g., an electrostatic withstand voltage that can be applied to the blue LED chips 102).

According to Embodiment 1, nothing is provided on a surface opposite to the upper surface of the substrate 101 (hereinafter, referred to as a back surface). However, Embodiment 1 is not particularly limited to such, and it is preferable to provide any cooling means on the back surface.

For example, a configuration can be employed in which a finned heat sink is provided on the back surface of the substrate 101 which also serves as a heat radiation plate for the light emitting apparatus of substrate shape. With the configuration, in a case where the light emitting apparatus of the present invention is placed, for example, in a room of a cultivation and culture factory, it is possible for the finned heat sink to cool down the substrate 101 when air flow is used in such a room. Note that, in this case, it is preferable that an opening of the finned heat sink is set to be pointed in a direction of the air flow.

Alternatively, a tube through which a nutrient solution flows can be provided on the back surface of the substrate 101. This makes it possible to suitably cool down the light emitting apparatus 100, and it is therefore possible to stably emit light which matches the optical absorption peaks of the optical absorption characteristics of chlorophyll.

### (Target living thing)

The light emitting apparatus of the present invention is capable of mainly cultivating or culturing a living thing by irradiating the living thing with light. The living thing which can be cultivated or cultured by the light emitting apparatus of the present invention is a photosynthetic living thing. Examples of the living thing include (i) living things which can be cultivated or cultured by light, that is, green plants such as mugwort, eggplant, cabbage, marigold, cucumber, sunflower, cauliflower, broccoli, and Japanese mustard spinach, (ii) brown algae such as seaweed, (iii) diatoms such as moss, (iv) haptophytes such as haptophyta, (v) cryptophyte algae such as dinoflagellate, (vi) green algae such as sea lettuce and spirogyra, (vii) blue algae such as spirulina, (viii) and bacteria referred to as photosynthetic bacteria. However, Embodiment 1 is not limited to those living things.

### (Light emitting section for illumination)

The light emitting apparatus 100 is a light emitting apparatus mainly for cultivation or culture of a living thing. It is not appropriate to use the light emitting apparatus 100 as it is as a light emitting apparatus for illumination necessary for human operation.

As has been described, according to the present invention, the number of the light emitting sections is not limited to two, and therefore three or more light emitting sections can be provided.

Here, a light emitting section for illumination is further provided to the light emitting apparatus 100, and a configuration of a light emitting apparatus thus obtained is described below which simultaneously emits (i) light for illumination necessary for human operation and (ii) light for cultivation or culture of a living thing.

For example, the light emitting apparatus including the three light emitting sections is configured such that (i) three sets of electrode lands are formed and (ii) light emitting sections are provided in a triple-spiral shape, instead of a double-spiral shape. However, Embodiment 1 is not limited to such.

That is, in addition to the first and second light emitting sections, a third light emitting section, serving as the light emitting section for illumination, is provided in which red phosphors 7b and green phosphors 7c are dispersed in a resin 7a of a resin layer covering an upper part of each of a plurality of blue LED chips 2.

The green phosphors are not limited in particular, provided that conventionally known phosphors are employed which absorb light in the blue region (wavelength ranging from 400 nm to 480 nm) and then emit light having an emission peak wavelength ranging from 500 nm to 600 nm. Examples of the green phosphors include (Ba, Sr)₂SiO₄:Eu.

Note here that it is possible to control light emission of the third light emitting section, independently of the first and second light emitting sections.

The third light emitting section is preferably arranged such that a compound ratio (weight ratio) between the resin 7a, the red phosphors 7b, and the green phosphors 7c is, for example, 1 : 0.01 : 0.10.

This allows (i) blue light and red light to be emitted which are adapted to an absorption spectrum of chlorophyll and (ii) an increase in quantity of light of a wavelength of near 500 nm with which a human feels brightest. Therefore, the third light emitting section is useful as an illumination light source for a human to work in space in which a living thing is cultivated or cultured.

The third light emitting section can be arranged so as to emit light simultaneously with the first and second light emitting sections. Alternatively, the third light emitting section can be arranged so as to emit light independently of the first and second light emitting sections.

### (Method of manufacturing light emitting apparatus)

The following description will discuss a method of manufacturing the light emitting apparatus of Embodiment 1. Note that a dimension of each member shown below is merely illustrative, and the light emitting apparatus 100 is not limited to such dimensions.

### <Step of forming wires and electrode lands>

First, the wires and the electrode lands 110 through 113 are formed on the substrate 101. Specifically, the substrate 101 is prepared which has a predetermined size (dimensions: 24 mm x 20 mm, thickness: 1 mm). Then, an electric conductor pattern, made of gold (Au), is formed on the upper surface of the substrate 101 by use of printed wiring so that the wires (width: 300 µm, thickness: 10 µm) are formed. Thereafter, an electric conductor pattern, made of silver and platinum (Ag-Pt), is formed on the upper surface of the substrate 101 by use of printed wiring so that the electrode lands 110 through 113 (length: 3.5 mm, width: 1.4 mm, thickness: 20 µm) are formed. The wires and the electrode lands 110 through 113 are thus formed in respective predetermined areas.

### <Step of forming printed resistive elements>

Next, a paste containing a resistive component is applied to the substrate 101 by screen printing. The substrate 101 is then baked in an electric furnace so that the paste is fixed on the substrate 101. As a result, the printed resistive elements 104 (width: 0.2 µm, thickness: 10 µm, resistance value: 1 MΩ) each serving as a protective element are formed. Note that the paste is mainly made of ruthenium oxide (RuO₂). The printed resistive elements 104 are thus formed in respective predetermined areas.

### <Bonding step>

Next, the blue LED chips 102 are formed on the upper surface of the substrate 101. Specifically, fifty two (52) blue LED chips 102 are first die-bonded to respective predetermined areas (from an outer side toward a center) with the use of, for example, silicone resin. Note that an electric connection is made between respective two adjacent blue LED chips 102, by wire-bonding their respective anode chip electrodes and wire-bonding their respective cathode chip electrodes.

The anode chip electrodes are then electrically connected to the respective electrode lands (cathode electrodes) by wire-bonding with the use of the respective wires 103. On the other hand, the cathode chip electrodes are electrically connected to the respective electrode lands (anode electrodes) by wire-bonding with the use of the respective wires 103.

### <Step of forming resin dams>

Next, the first resin dam 105 and the second resin dam 106 are formed on the substrate 101. Specifically, liquid white silicone resin (containing a light diffusion filler TiO₂) is applied to predetermined areas with the use of, for example, a dispenser. That is, after the liquid white silicone resin is applied to an area where the first resin dam 105 is to be formed, the liquid white silicone resin is applied to an area where the second resin dam 106 is to be formed. In so doing, a starting point of the formation of the second resin dam 106 is in contact with the first resin dam 105, and an end point of the formation of the second resin dam 106 is also in contact with the first resin dam 105. The second resin dam 106 is not in contact with the blue LED chips 102.

Then, by heat-curing the liquid white silicone resin at a temperature of 150°C for 60 minutes, the first resin dam 105 (width: 1 mm, a ring diameter: 16 mm) and the second resin dam 106 (width: 0.5 mm) are formed. Note that the above temperature and time are merely illustrative, and Embodiment 1 is not therefore limited to those.

### <Step of forming phosphor-containing resin layer>

Next, the phosphor-containing resin layer 107 is formed on the upper surface of the substrate 101. Specifically, a resin containing phosphor particles is produced in advance by dispersing, in liquid transparency silicone resin, particulate red phosphors 109. The resin containing the red phosphors is then infused into one of the regions enclosed by the respective first and second resin dams 105 and 106 so that the one of the regions is filled with the resin containing the red phosphors.

After being infused into the one of the regions, the resin containing the red phosphors is heat-cured at a temperature of 150°C for 30 minutes so that the phosphor-containing resin layer 107 is formed. Note that the temperature and time are merely illustrative, and Embodiment 1 is not therefore limited to those. As compared with epoxy resin, use of silicone resin causes a less deterioration in resin and, accordingly, ultimately allows an increase in reliability.

### <Step of forming light-permeable resin layer>

Next, the light-permeable resin layer 108 is formed on the upper surface of the substrate 101. Specifically, liquid transparent silicone resin is infused into the other of the regions enclosed by the respective first and second resin dams 105 and 106 so that the other of the regions is filled with the liquid transparent silicone resin. The liquid transparent silicone resin is then heat-cured at a temperature of 150°C for 5 hours so that the light-permeable resin layer 108 is formed.

The light-permeable resin layer 108 is thus formed in a predetermined area. That is, the light-permeable resin layer 108 is formed so as to wholly seal the blue LED chips 102 and to draw a spiral when viewed from above. In this way, the light emitting apparatus 100 as illustrated in Fig. 1 is prepared.

### [Embodiment 2]

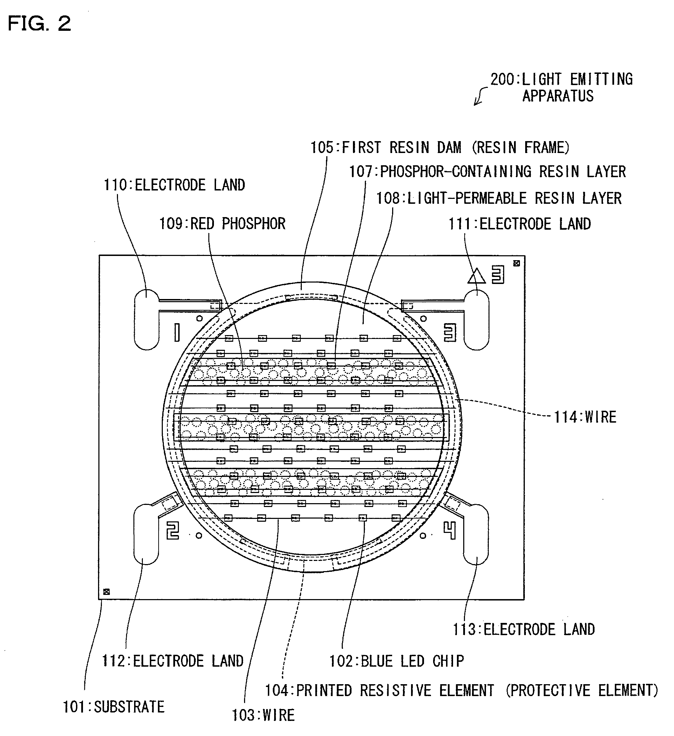

Fig. 2 is a plane view illustrating an example configuration of a light emitting apparatus 200 in accordance with Embodiment 2. The following description will discuss the configuration and a structure of the light emitting apparatus 200. Note, however, that a configuration and a structure which are not described in Embodiment 2 are identical to those of the light emitting apparatus 100 of Embodiment 1.

### (Basic configuration of light emitting apparatus)

The light emitting apparatus 200 includes a substrate 101, blue LED chips 102, a first resin dam 105, phosphor-containing resin layers 107 (resin layers), red phosphors 109, and light-permeable resin layers 108 (resin layers).

As with Embodiment 1, electrode lands 110 and 112 each function as an anode electrode, and electrode 111 and 113 each function as a cathode electrode. The phosphor-containing resin layers 107 and the light-permeable resin layers 108 are formed in a region inside the first resin dam 105. Note, however, that no second resin dam is formed, unlike Embodiment 1.

With the configuration, no second resin dam is formed, and the phosphor-containing resin layers 107 and the light-permeable resin layers 108 are formed so as to be directly adjacent to each other. Therefore, it is possible to efficiently emit further improved mixed-color light.

Each of the phosphor-containing resin layers 107 is a resin layer made of resin containing the red phosphors 109. Each of the light-permeable resin layers 108 is formed in the region inside the first resin dam 105 having a circular shape so as to embed the blue LED chips 102 and wires 103 formed in the region.

According to Embodiment 2, the phosphor-containing resin layers 107 are formed so as to individually seal a plurality of groups into which the blue LED chips 102 are divided. This causes the phosphor-containing resin layers 107 to be formed in stripes when viewed from above, in respective three regions.

Specifically, in a case where (i) a right-and-left direction of Fig. 2 is defined as a lateral direction and (ii) up and down of Fig. 2 are defined as an up-and-down direction or up and down, the phosphor-containing resin layers 107 are formed, in the lateral direction inside a circle formed by the first resin dam 105, in stripes in the respective three regions so as to be in contact with the first resin dam 105. One of the phosphor-containing resin layers 107 in the respective three regions is formed at a center of the circle formed by the first resin dam 105, whereas the others of the phosphor-containing resin layers 107 are formed, symmetrically with respect to the center of the circle, on an upside and a downside of the one of the phosphor-containing resin layers 107 which is formed at the center of the circle.

Each of the light-permeable resin layers 108 is a sealing resin layer made of resin. Each of the light-permeable resin layers 108 is formed in the region inside the first resin dam 105 so as to embed the blue LED chips 102 and wires 103 provided in the region. That is, the light-permeable resin layers 108 are formed so as to individually seal a plurality of groups into which the blue LED chips 102 are divided.

This causes the light-permeable resin layers 108 to be formed in stripes when viewed from above, in respective four regions so that the light-permeable resin layers 108 are in contact with the first resin dam 105. That is, the light-permeable resin layers 108 are formed so as to fill in the respective four regions enclosed by the first resin dam 105 and the phosphor-containing resin layers 107.

According to Embodiment 2, the blue LED chips 102 and the wires 103 are formed in two lines in each of such seven regions, that is, the three regions formed by the phosphor-containing resin layers 107 and the four regions formed by the light-permeable resin layers 108.

Wires electrically connected to the electrode lands 110 through 113 are embedded in the first resin dam 105.

CaAlSiN₃:Eu phosphors each having an emission peak wavelength of near 650 nm are employed as the red phosphors 109 of Embodiment 2 each of which is a particulate phosphor.

This causes (i) each of the regions, in which the phosphor-containing resin layers 107 are formed, to serve as a first light emitting section which emits blue light and red light due to "blue LED chips + red phosphors" and (ii) each of the regions, in which the light-permeable resin layers 108 are formed, to serve as a second light emitting section which emits blue light due to "blue LED chips".

### (Method of manufacturing light emitting apparatus)

The light emitting apparatus 200 having the above configuration can be manufactured by steps and in order identical to those of the method of manufacturing the light emitting apparatus 100 described with reference to Fig. 1 in Embodiment 1.

In a step of forming phosphor-containing resin layers, the phosphor-containing resin layers 107 are formed on an upper surface of the substrate 101 as illustrated in Fig.2. Specifically, a resin containing phosphor particles, the resin being obtained by dispersing the red phosphors in a transparent silicone resin, is placed on predetermined areas so that the phosphor-containing resin layers 107 are formed.

Note that the silicone resin of each of the phosphor-containing resin layers 107 is a silicone resin which has high thixotropy and does not have flowability. This silicone resin which has high thixotropy and does not have flowability is realized by mixing a thixotropy addition agent with resin.

This causes each of the phosphor-containing resin layers 107 to increase in viscosity and accordingly to become solidified without being heat-cured after being placed on the upper surface of the substrate 101. That is, the phosphor-containing resin layers 107 are formed, in stripes when viewed from above, so as to seal the blue LED chips 102.

By thus employing, as each of the phosphor-containing resin layers 107, a resin which is higher in thixotropy (higher in viscosity) than that of each of the light-permeable resin layers 108, it becomes unnecessary to heat-cure the phosphor-containing resin layers 107 at that time.

In a step of forming light-permeable resin layer, each of the phosphor-containing resin layers 107 functions as a so-called resin dam (resin wall) as in Embodiments which is used to form the light-permeable resin layers 108. That is, each of the phosphor-containing resin layers 107 can be used as a dam material without being cured. The light-permeable resin layers 108 are formed between the phosphor-containing resin layers 107.

The light emitting apparatus 200 illustrated in Fig. 2 can be thus prepared. According to the light emitting apparatus 200, it is possible to independently control light to be emitted from the phosphor-containing resin layers 107 and from the light-permeable resin layers 108, by connecting an external terminal to each of the electrode lands 110 through 113 and then supplying electric power to the electrode lands 110 through 113.

It is thus possible to independently drive the first and second light emitting sections. This allows each of the first and second light emitting sections to independently emit light. As such, by controlling a condition (emission intensity) on which each of the first and second light emitting sections emits light, it is possible to easily control a ratio between (i) a photosynthetic photon flux at a wavelength of 450 nm in a blue region and (ii) a photosynthetic photon flux at a wavelength of 650 nm in a red region so as to be approximately 1 : 10.

The light emitting apparatus of Embodiment 2 is particularly suitable to culture algae.

### [Embodiment 3]

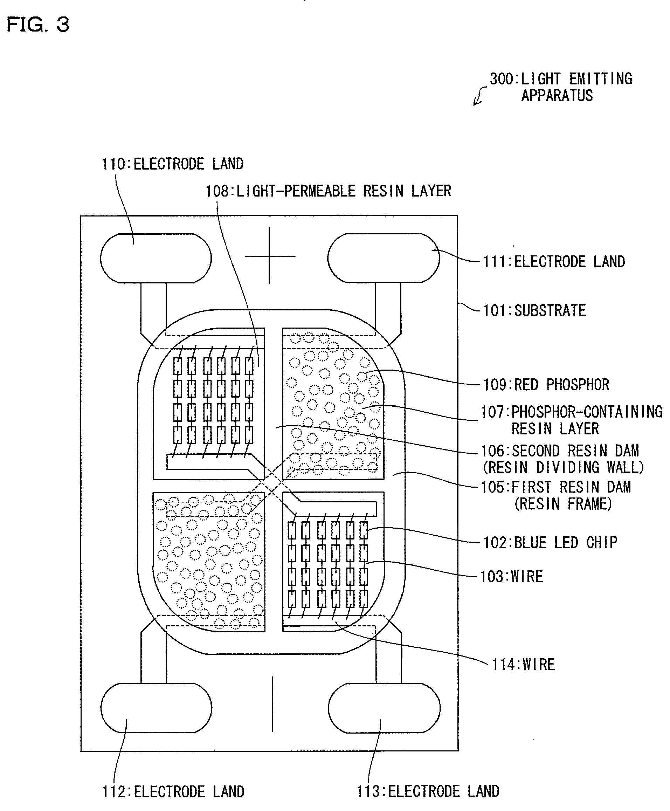

Fig. 3 is a plane view illustrating an example configuration of a light emitting apparatus 300 in accordance with Embodiment 3. The following description will discuss the configuration and a structure of the light emitting apparatus 300. Note, however, that a configuration and a structure which are not described in Embodiment 3 are identical to those of the light emitting apparatus 100 of Embodiment 1.

### (Basic configuration of light emitting apparatus)

Phosphor-containing resin layers 107 are provided so as to individually seal a plurality of groups into which blue LED chips 102 are divided. According to Embodiment 3, the phosphor-containing resin layers 107 are formed in respective two regions.

Light-permeable sealing resin layers 108 are provided so as to individually seal blue LED chips 102. According to Embodiment 3, the number of the light-permeable resin layers 108 is two. A first resin dam 105 and a second resin dam 106 are formed, when viewed from above, in a lattice so as to have parallel lines in an up-and-down direction and in a right and left direction. Specifically, out of such resin dams formed in the lattice, the first resin dam 105 is provided in a quadrangle, and the second resin dam 106 is provided in a cross so as to continue with the first resin dam 106.

The phosphor-containing resin layers 107 and the light-permeable sealing resin layers 108 are provided in respective regions enclosed by the first resin dam 105 and the second resin dam 106.

Further, the first resin dam 105 has four rounded corners adjacent to the respective electrode lands 110 through 113. That is, the first resin dam 105 and the second resin dam 106 are provided, in the lattice, so as to have four rounded corners.

Out of the four regions enclosed by the first resin dam 105 and the second resin dam 106 formed in the lattice, the light-permeable sealing resin layers 108 are provided for the respective electrode lands 110 and 113, and the phosphor-containing resin layer 107 are provided for the respective electrode lands 111 and 112.

With the configuration, each of the regions, in which the phosphor-containing resin layers 107 are provided, serves as a first light emitting section which emits blue light and red light due to "blue LED chips + red phosphors." Each of the regions, in which the light-permeable sealing resin layers 108 are provided, serves as a second light emitting section which emits blue light due to "blue LED chips".

In each light emitting section, the blue LED chips 102 are arranged at regular intervals in six lines in an up-and-down direction. The blue LED chips 102 are connected to each other in the up-and-down direction with the use of wires 103 so that each of the blue LED chips 102 can emit light. Two wires, each extending over between corresponding two regions which serve as identical light emitting sections, are formed so that the corresponding two regions are electrically connected to each other. The wire which connects the first light emitting sections and the wire which connects the second light emitting sections, are formed so as not to electrically contact with each other around a central part, e.g., so as to cross each other in respective different heights.

(Sr,Ca) AlSiN₃:EU phosphors, each having an emission peak wavelength which falls within a range of 620 nm to 630 nm, are used as particulate red phosphors 109 contained in each of the phosphor-containing resin layers 107.

According to the light emitting apparatus 300, the blue LED chips 102 are connected. Specifically, the blue LED chips 102 of type I (emission peak wavelength within a range of 430 nm to 440 nm) are sealed in each of the regions in which the phosphor-containing resin layers 107 are provided. The blue LED chips 102 of type II (emission peak length within a region of 450 nm to 460 nm) are sealed in each of the regions in which the light-permeable sealing resin layers 108 are provided.

Meanwhile, as described in Embodiment 1, blue light having an emission peak wavelength which falls within the range of 450 nm to 460 nm also affects light reaction of plants called high-energy reaction system and is, accordingly, essential for healthy morphogenesis of such plants. Therefore, at a germination and nursery stage, a blue optical element increases in important.

In view of the circumstances, by causing the regions in which the light-permeable sealing resin layers 108 are provided, that is, the second light emitting sections to emit blue light due to "blue LED chips" or by causing the second light emitting sections to emit light more intensively than the first light emitting sections, it is possible to provide a light emitting apparatus serving as an LED light source for plant cultivation which apparatus easily emit light having a blue optical element essential for healthy morphogenesis of a plant at the germination and nursery stage.

### [Embodiment 4]

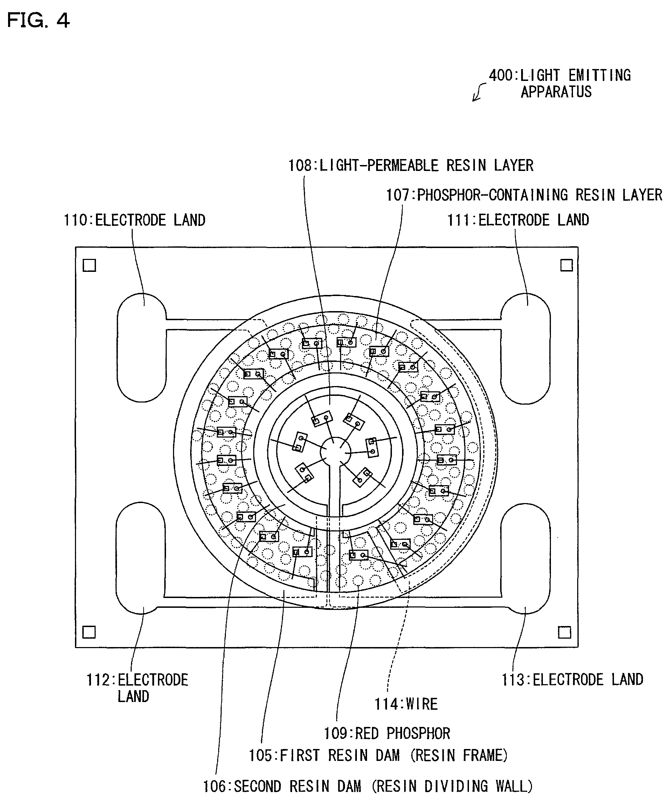

Fig. 4 is a plane view illustrating an example configuration of a light emitting apparatus 400 in accordance with Embodiment 4. The following description will discuss the configuration and a structure of the light emitting apparatus 400. Note, however, that a configuration and a structure which are not described in Embodiment 4 are identical to those of the light emitting apparatus 300 of Embodiment 3.

### (Basic configuration of light emitting apparatus)

As illustrated in Fig. 4, the light emitting apparatus 400 includes a plurality of blue LED chips 102 electrically connected.

A phosphor-containing resin layer 107 is provided so as to seal first blue LED chips 102. A light-permeable sealing resin layer 108 is provided so as to seal second blue LED chips 102. The phosphor-containing resin layer 107 and the light-permeable sealing resin layer 108 each form a circle in a region inside a first resin dam 105 when viewed from above.

CaAlSiN₃:Eu phosphors each having an emission peak wavelength of near 650 nm are employed, as particulate red phosphors 109 contained in the phosphor-containing resin layer 107,

This causes (i) a region in which the phosphor-containing resin layer 107 is provided to serve as a first light emitting section which emits blue light and red light due to "blue LED chips (corresponding to chlorophyll b) + red phosphors" and (ii) a region in which the light-permeable resin layer 108 is provided to serve as a second light emitting section which emits blue light due to "blue LED chips (corresponding to chlorophyll a)".

Note that, according to Embodiment 4, the blue LED chips 102 (type II), which are covered by the phosphor-containing resin layer 107, has an emission peak falling within a wavelength range of 450 nm to 460 nm which matches the optical absorption peak of chlorophyll b, whereas the blue LED chips 102 (type I), which are covered by the light-permeable resin layer 108, has an emission peak falling within a wavelength range of 430 nm to 440 nm which matches the optical absorption peak of chlorophyll a.

Chlorophyll is known to be used to whiten skin, perform facial treatment, prevent acne, and prevent inflammation of skin. Usage examples of the light emitting apparatus of the present invention include providing of chlorophyll by extracting from seaweed, plants of genus Artemisia of the family Asteraceae, spirulina, or the like each of which is cultured or cultivated with the use of the light emitting apparatus of the present invention.

Note that the present invention is not limited to Embodiments 1 through 4, but may be altered by a skilled person in the art within the scope of the claims. An embodiment derived from a proper combination of technical means disclosed in different embodiments is also encompassed in the technical scope of the present invention.

Note further that the present invention is made based on the following premised technique. That is, the present invention is directed to a light emitting apparatus including (i) a first light emitting section which includes blue LED chips and red phosphors as in a configuration of a first light emitting section using the premised technique and (ii) a second light emitting section which includes only blue LED chips. The following description will discuss the premised technique including only the first light emitting section.

### [Premised Technique]

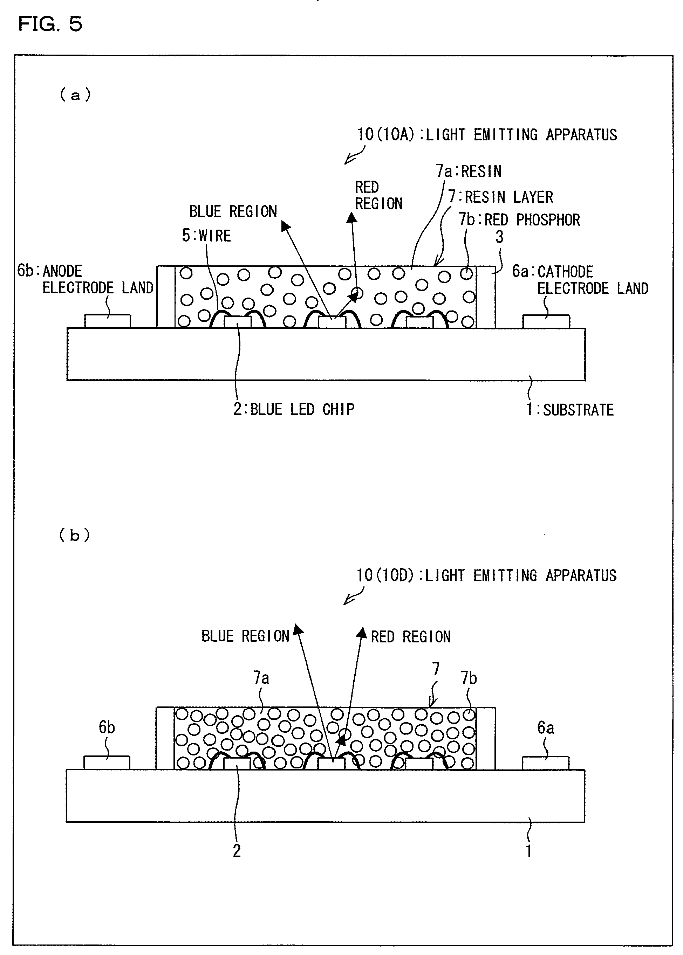

The following description will discuss the premised technique with reference to Figs 5 through 11, and 13. That is, the present invention is made based on the following primed technique.

### (Configuration of light emitting apparatus using premised technique)

The following description will discuss, with reference to (a) and (b) of Fig.6, a configuration of a light emitting apparatus for plant cultivation which apparatus uses the premised technique. (a) of Fig. 6 is a plane view illustrating the light emitting apparatus for plant cultivation in which resin containing red phosphors has not been infused. (b) of Fig. 6 is a plane view illustrating the light emitting apparatus in which the resin containing red phosphors has been infused.

A light emitting apparatus 10 of substrate-type, which serves as the light emitting apparatus for plant cultivation and which uses the premised technique, is configured such that blue LED chips 2 are provided on a substrate 1 and a resin dam 3 made of resin is provided so as to surround the blue LED chips 2.

According to the premised technique, 24 blue LED chips 2 are arranged so as to have 8 lines of blue LED chips 2, each of which lines is made up of 3 blue LED chips 2 serially connected to each other and which lines are connected to each other in parallel. Note, however, that, according to the present invention, the number of the blue LED chips 2 is neither necessarily limited to be plural nor 24. As such, the light emitting apparatus 10 of substrate-type can include only a single blue LED chip 2. Moreover, how to arrange the blue LED chips 2 and how to electrically connect the blue LED chips 2, are not particularly limited.

Inside the resin dam 3, each of the blue LED chips 2 arranged in a line is connected, via two wires 5 which are electrically conductive, to wires 4a and 4b provided at both sides of the line. The wires 4a and 4b are connected to a cathode electrode land 6a and an anode electrode land 6b, respectively, each of which is provided on the substrate 1 and outside of the resin dam 3.

Further, according to the light emitting apparatus 10 of substrate-type, a resin layer 7 is provided which fills inside of the resin dam 3 and which covers an upper part of each of the blue LED chips 2 (see (b) of Fig. 6). In this resin layer 7, red phosphors 7b are mixed and dispersed.

Each of the blue LED chips 2 emits blue light having a wavelength falling within a range of 400 nm to 480 nm which matches an absorption peak in a blue region of chlorophyll. Each of the red phosphors 7b absorbs light from the blue LED chips 2 and then emits red light having an emission peak wavelength falling within a range of 620 nm to 700 nm which matches an absorption peak in a red region of chlorophyll

Note that each of the blue LED chips 2 can emit not only blue light having the wavelength falling within a range of 400 nm to 480 nm which matches the absorption peak in the blue region of chlorophyll but also light having wavelengths in a blue-ultraviolet region containing a ultraviolet region.

### (Controlling of ratio between quantity of blue light and quantity of red light)

With reference to (a) and (b) of Fig. 5 and Fig. 7, the following description will discuss how the light emitting apparatus 10 of substrate-type controls a ratio between a quantity of light in the blue region and a quantity of light in the red region. (a) and (b) of Fig. 5 are cross-sectional views schematically illustrating respective configurations of LED light sources 10(10A) and 10(10D) of substrate-type which are different from each other in compound ratio between red phosphors and a silicone resin.

According to the light emitting apparatus 10 of substrate-type, the resin layer 7 includes (i) a resin 7a made of silicone resin and (ii) red phosphors 7b dispersed in the resin 7a (see (a) of Fig. 5). Therefore, by changing a ratio between the red phosphors 7b and the resin 7a, it is possible to emit light having different wavelengths.

For example, a CaAlSiN₃:Eu phosphor is used as the red phosphors 7b and, as described earlier, the blue LED chips 2 emit light having an emission peak within a wavelength range of 400 nm to 480. With the configuration, blue light having an emission peak wavelength falling within a range of 400 nm to 480 nm and red light having an emission peak wavelength falling within a range of 620 nm to 700nm are emitted.

Specifically, in a case where a light emitting apparatus 10A of substrate-type has a compound ratio (weight ratio) of 1 : 0.05 between the resin 7a and the red phosphors 7b (see (a) of Fig. 5), an emission spectrum having (i) a peak wavelength 440 nm at which an emission intensity is 1.0 and (ii) a peak wavelength 640 nm at which an emission intensity is 0.3 is obtained (see (a) of Fig. 7).

In a case where a LED light source 10B of substrate-type has a compound ratio (weight ratio) of 1 : 0.10 between the resin 7a and the red phosphors, a spectrum (i) having (i) a peak wavelength 440 nm at which an emission intensity is 1.0 and (ii) a peak wavelength 640 nm at which an emission intensity is 0.8 is obtained (see (b) of Fig. 7).

Further, in a case where a LED light source 10C of substrate-type has a compound ratio (weight ratio) of 1 : 0.15 between the resin 7a and the red phosphors 7b, a spectrum having (i) a peak wavelength 440 nm at which an emission intensity is 0.56 and (ii) a peak wavelength 640 nm at which an emission intensity is 1.0 is obtained (see (c) of Fig. 7).

In a case where the light emitting apparatus 10D of substrate-type has a compound ratio (weight ratio) of 1 : 0.20 between the resin 7a and the red phosphors 7b (see (b) of Fig. 5), a spectrum having (i) a peak wavelength 440 nm at which an emission intensity is 0.4 and (ii) a peak wavelength 640 nm at which an emission intensity is 1.0 is obtained (see (d) of Fig. 7).

As described, it is possible to easily control a ratio between a quantity of blue light and a quantity of red light by changing the compound ratio (weight ratio) between the resin 7a and the red phosphors 7b.

### (Wavelength necessary for plant growth)

Next, the following description will discuss, with reference to Fig. 8, which wavelength of light is suitable for plant growth. Fig. 8 is a view illustrating (i) optical absorption spectra of chlorophyll and (ii) emission spectra of the light emitting apparatus 10 of substrate-type.

As has been described, chlorophyll, which plays a main role in photosynthesis of a plant, does not uniformly absorb light. Chlorophyll has clear absorption peaks near a wavelength of 660 nm in the red region and near a wavelength of 450 nm in the blue region. In association with such absorption peaks, a wavelength characteristic required for photosynthesis has a first peak near a wavelength of 660 nm and a second peak near a wavelength of 450 nm.

Therefore, at a maturation stage at which a plant grows to have a leaf and becomes active in photosynthesis, light having both red and blue optical elements is effective for growth.

Meanwhile, blue light having a wavelength of near 450 nm also affects light reaction of plants called high-energy reaction system and is, accordingly, essential for healthy morphogenesis of specific plants. Therefore, at a germination and nursery stage, the blue optical element increases in importance.

In this regard, according to the light emitting apparatus 10 of substrate-type, the light emitting apparatus 10A of substrate-type is suitable for an absorption range in the blue region of chlorophyll, whereas the light emitting apparatus 10D of substrate-type is suitable for an absorption range in the red region of chlorophyll.

According to the light emitting apparatus 10 of substrate-type, it is possible to easily match between an emission characteristic of the light emitting apparatus 10 of substrate-type and an optical absorption characteristic of chlorophyll, only by changing the compound ratio (weight ratio) between the resin 7a and the red phosphors 7b.

Meanwhile, in the field of optics, a quantity of light is expressed in terms of, for example, photon flux density. Note here that the photon flux density indicates a value obtained by dividing, by an area of a light receiving surface of an physical object, the number of photons with which the light receiving surface is irradiated per second.

In a case of using the photon flux density, the number of photons is counted. Therefore, the number to be counted is the same both in a case of infrared light and in a case of ultraviolet light. On the other hand, a photochemical reaction occurs only when photons that a pigment can absorb are received. As such, for example, receiving light that chlorophyll cannot absorb means nothing to plants. In view of the circumstances, in the field of photosynthesis, "photosynthetic photon flux density" and "photosynthetic photon flux" are defined only for light whose wavelength ranges from 400 nm to 700 nm which light chlorophyll can absorb. Note that the photosynthetic photon flux is obtained by multiplying the photosynthetic photon flux density (PPFD) by an area which receives light.

The above values do not merely express, in terms of energy, the absorption peak wavelengths in the red region and in the blue region of chlorophyll but expresses, in terms of the number of photons, energy (i.e., energy necessary for photosynthesis) corresponding to the absorption spectra in the red region and in the blue region for the purpose of finding light intensity necessary for plant growth.

Note that the photosynthetic photon flux can be found from (i) emission spectral characteristics of light emitted from a light emitting apparatus and energy of one photon per wavelength.

According to the light emitting apparatus 10A of substrate-type illustrated in (a) of Fig. 7, a ratio, between (i) the photosynthetic photon flux in the blue region ranging from 400 nm to 480 nm and (ii) the photosynthetic photon flux in the red region ranging from 620 nm to 700 nm, is 1 : 1.3.

Further, according to the light emitting apparatus 10B of substrate-type illustrated in (b) of Fig. 7, a ratio between (i) the photosynthetic photon flux in the blue region ranging from 400 nm to 480 nm and (ii) the photosynthetic photon flux in the red region ranging from 620 nm to 700 nm is 1 : 3.5.

According to the LED light source 10C of substrate-type illustrated in (c) of Fig, 7, a ratio between (i) the photosynthetic photon flux in the blue region ranging from 400 nm to 480 nm and (ii) the photosynthetic photon flux in the red region ranging from 620 nm to 700 nm is 1 : 7.5.

According to the light emitting apparatus 10D of substrate-type illustrated in (d) of Fig. 7, the ratio between (i) the photosynthetic photon flux in the blue region ranging from 400 nm to 480 nm and (ii) the photosynthetic photon flux in the red region ranging from 620 nm to 700 nm is 1 : 10.

That is, in cases where the premised technique is used, the ratio, between (i) the photosynthetic photon flux in the blue region ranging from 400 nm to 480 nm and (ii) the photosynthetic photon flux in the red region ranging from 620 nm to 700 nm, falls within a ratio of 1 : 1.3 to 1 : 10. In view of the fact, it is preferable to employ the light emitting apparatus 10 of substrate-type which is suitable for germination, nursery, and maturation of a plant.

Specifically, in a case where it is intended that the light emitting apparatus 10 of substrate-type is provided on a germination shelf or a nursery shelf so as to grow a plant, it is preferable to employ the light emitting apparatuses 10A and 10B of substrate-type whose ratio, between (i) the photosynthetic photon flux in the blue region ranging from 400 nm to 480 nm and (ii) the photosynthetic photon flux in the red region ranging from 620 nm to 700 nm, falls within a ratio of 1 : 1.3 to 1 : 3.5. This makes it possible to cause the light emitting apparatuses 10A and 10B of substrate-type to be suitable for germination and nursery of a plant.

Alternatively, in a case where it is intended that the light emitting apparatus 10 of substrate-type is provided on a maturation shelf so as to grow a plant, it is preferable to employ the light emitting apparatuses 10C and 10D of substrate-type whose ratio, between (i) the photosynthetic photon flux in the blue region ranging from 400 nm to 480 nm and (ii) the photosynthetic photon flux in the red region ranging from 620 nm to 700 nm, falls within a ratio of 1 : 7.5 to 1 : 10. This makes it is possible to cause the light emitting apparatuses 10C and 10D of substrate-type to be suitable for maturation of a plant.

Fig. 9 illustrates how relative luminous flux is changed depending on temperature in each of the light emitting apparatus 10 of substrate-type and a conventional single red LED for plant cultivation. In Fig. 9, a horizontal axis represents a junction temperature of a mounted chip, and a vertical axis represents the relative luminous flux. As is clear from Fig. 9, a difference of about 10% in the relative luminous flux occurs, in a high-temperature region near 100°C, between the light emitting apparatus 10 of substrate-type (shown by a solid line in Fig. 9) and the conventional single red LED for plant cultivation (shown by a broken line in Fig. 9). This is because the red LED is poor in temperature characteristic. Note here that the bullet-shaped red LED lamp is a light emitting apparatus prepared based on Embodiments of and Figs. 1 and 2 disclosed in Patent Literature 2.

It is thus demonstrated that the light emitting apparatus 10 of substrate-type can emit light having optical elements which are stabler from low temperatures to high temperatures, as compared with the conventional bullet-shaped red LED lamp.

According to the light emitting apparatus 10 of substrate-type, the red phosphors 7b are used instead of the red LED. This causes an improvement in temperature characteristic. According to the light emitting apparatus 10 of substrate-type and a bullet-type LED lamp 40 (later described), their emission peaks can well match the optical absorption peaks of the optical absorption characteristic of chlorophyll.

### (Red phosphors)

Note here that, in the above description, the light emitting apparatus 10 of substrate-type includes a CaAlSiN₃:Eu phosphor as the red phosphors 7b. However, the red phosphors 7b are not limited to the CaAlSiN₃:Eu phosphor. Alternatively, a (Sr,Ca)AlSiN₃:Eu phosphor can be employed as the red phosphors 7b. Note that the (Sr,Ca)AlSiN₃:Eu phosphor is a phosphor obtained from the CaAlSiN₃:Eu phosphor by replacing part of Ca with Sr so that an emission peak wavelength is shifted toward a shorter wavelength. As with the CaAlSiN₃:Eu phosphor, the (Sr,Ca)AlSiN₃:Eu phosphor has a stable temperature characteristic and high luminous efficiency.

Specifically, it is preferable to employ, as the red phosphors 7b, the CaAlSiN₃:Eu phosphor (whose emission peak wavelength falls within a range of 650 nm to 660 nm) for a plant or the like containing a large amount of chlorophyll a (red region referred to as a Q band). Alternatively, it is preferable to employ, as the red phosphors 7b, the (Sr,Ca)AlSiN₃:Eu phosphor (whose emission peak is at a short wavelength side (620 nm to 630), as compared with that of the CaAlSiN₃:Eu phosphor) for a plant or the like containing a large amount of chlorophyll b.

Alternatively, 3.5MgO·0.5MgF₂·GeO₂:Mn, La₂O₂S:Eu, Y₂O₂S:Eu, LiEuW₂O₈, (Y, Gd, Eu)₂O₃, (Y, Gd, Eu)BO₃, YVO₄:Eu, and/or CaS:Eu, Ce, K can be also used as the red phosphors 7b.

It goes without saying that two types of the red phosphors 7b, e.g., the CaAlSiN₃:EU phosphor and the (Sr,Ca)AlSiN₃:Eu phosphor, can be used in combination. The use of the two types of the red phosphors 7b is effective to cultivate a plant containing chlorophyll a and chlorophyll b.

In regard to the optical absorption characteristic in the blue region of chlorophyll, the peak wavelength of light emitted from the blue LED chips 2 can be set as appropriate so as to match the absorption peaks of chlorophyll a and chlorophyll b. For example, it is preferable to use the blue LED chips 2 (type I) each of which emits light having a peak wavelength ranging from 430 nm to 440 nm for a plant containing a large amount of chlorophyll a. Alternatively, it is preferable to use the blue LED chips 2 (type II) each of which emits light having a peak wavelength ranging from 450 nm to 460 nm for a plant containing a large amount of chlorophyll b.

Furthermore, the LED light source 10 of substrate-type can be arranged such that a combination of the blue LED chips 2 and the red phosphors 7b matches each type of chlorophyll a and chlorophyll b.

For example, the LED light source 10 of substrate-type can be arranged to include various combinations such as (i) a combination of the blue LED chip 2 of type I and the red phosphors 7b made of the CaAlSiN₃:Eu phosphor and (ii) a combination of the blue LED chips 2 of type II and the red phosphors 7b made of the (Sr,Ca)AlSiN₃:Eu phosphor.

In this case, in each arrangement, a compound ratio (weight ratio) between the resin 7a and the red phosphors 7b is controlled as appropriate so as to be a desired ratio.

### (Light emitting apparatus for illumination)

The light emitting apparatus 10 of substrate-type described above is a light emitting apparatus for plant cultivation. Therefore, it is not appropriate to use the light emitting apparatus 10 of substrate-type as it is as a light emitting apparatus for illumination necessary for human operation.

In view of the circumstances, the following description will discuss how to improve the light emitting apparatus 10 of substrate-type so as to obtain a light emitting apparatus 20 for illumination necessary for human operation.

That is, in addition to the aforementioned configuration of the LED light source 10 of substrate-type, green phosphors 7c, in addition to red phosphors 7b, are dispersed in a resin 7a of a resin layer 7 covering an upper part of each of blue LED chips 2 (see (a), (b), and (c) of Fig. 7).

Note here that the green phosphors which can be used are not limited in particular, provided that each of the green phosphors absorbs light emitted from the blue LED chips and then emits light having an emission peak around a wavelength of 550 nm. Examples of the green phosphors include (Ba, Sr)₂SiO₄:Eu, and (Si, Al)₆(O, N)₈:EU.

Specifically, the light emitting apparatus 20 for illumination is configured such that the blue LED chips 2 are provided on a substrate 1 and a resin dam 3 is provided so as to surround the blue LED chips 2.

According to the premised technique, 156 blue LED chips 2 are arranged so as to have 13 lines of blue LED chips 2, each of which lines is made up of 12 blue LED chips 2 serially connected to each other and which lines are connected to each other in parallel. Note, however, that, according to the present invention, the number of the blue LED chips 2 is neither necessarily limited to be plural nor 156. As such, the light emitting apparatus 20 for illumination can include only a single blue LED chip 2. Moreover, how to arrange the blue LED chips 2 is not particularly limited.

Inside the resin dam 3, each of the blue LED chips 2 arranged in a line is connected, via wire 5 which are electrically conductive, to wires 4a and 4b provided at both sides of the line. The wires 4a and 4b are connected to a cathode electrode land 6a and an anode electrode land 6b, respectively, each of which is provided on the substrate 1 and outside of the resin dam 3.

Further, according to the light emitting apparatus 20 for illumination, the resin layer 7 is provided so as to fill inside of the resin dam 3 and to cover the upper part of each of the blue LED chips 2 (see (b) of Fig. 10). In this resin layer 7, the red phosphors 7b and the green phosphors 7c are mixed and dispersed.

Note here that, according to the light emitting apparatus 20 for illumination, a compound ratio (weight ratio) between the resin 7a, the red phosphors 7b, and the green phosphors 7c is, for example, 1 : 0.01 : 0.10. This compound ratio (weigh ratio) gives an emission spectrum illustrated in (c) of Fig. 10. According to the emission spectrum illustrated in (c) of Fig. 10, a quantity of light is large at a wavelength of near 550 nm with which a human feels brightest. This shows that the LED light source 20 for illumination is effective as a illumination light source for human operation.

### (Application to plant factory)

Next, the following description will discuss, with reference to Fig. 11, an example application of the light emitting apparatus 10 of substrate-type to a plant factory. Fig. 11 is a view illustrating an example of a plant factory 30 in which a light emitting apparatus 10 of substrate-type and a light emitting apparatus 20 for illumination are used.

As illustrated in Fig. 11, in the plant factory 30, for example, 1300 light emitting apparatuses 10A of substrate-type are provided on germination shelves, 4600 light emitting apparatuses 10A of substrate-type are provided on nursery shelves, and 17000 light emitting apparatuses 10D of substrate-type are provided on maturation shelves. 3700 light emitting apparatus 20 for illumination are provided in a shipment room where a human works.

As has been described, the light emitting apparatus for plant cultivation using the premised technique includes (i) at least one blue LED chip 2 which has an emission peak falling within a wavelength range of 400 nm to 480 nm so as to match the absorption peak in the blue region of chlorophyll, (ii) the red phosphors 7b each of which emits, upon receipt of excitation light from the at least one blue LED chip 2, light having an emission peak falling within a wavelength range of 620 nm 700 nm so as to match the absorption peak in the red region of chlorophyll, and (iii) a resin layer 7 in which the red phosphors 7b are dispersed and which covers the at least one blue LED chip 2.

With the configuration, the light emitting apparatus for plant cultivation includes the at least one blue LED chip 2 and the resin layer 7 which covers the at least one blue LED chip 2 and in which the red phosphors 7b are dispersed. With the configuration, the at least one blue LED chip 2 emits light having the emission peak falling within a wavelength range of 400 nm to 480 nm so as to match the absorption peak in the blue region of chlorophyll, and the red phosphors 7b emit, upon receipt of excitation light from the at least one blue LED chip 2, light having the emission peak falling within a wavelength range of 620 nm to 700 nm so as to match the absorption peak in the red region of chlorophyll.

It follows that the light emitting apparatus requires only a single type of blue LED chip(s) 2, instead of separate two types of LED chips, i.e., a blue LED chip(s) 2 and a red LED chip(s), in order to emit light which matches the absorption peaks in the blue region and in the red region of chlorophyll which light is necessary for the growth of a plant. This causes the light emitting apparatus not to occupy a large area. Moreover, since the red phosphors 7b are dispersed in the resin layer, it is possible to disperse the red phosphors in the resin at a predetermined compound ratio (weight ratio). In accordance with the compound ratio (weight ratio), it is possible to change (i) a quantity of light in the blue region and (ii) a quantity of light in the red region.

It is therefore possible to provide an LED light source for plant cultivation capable of, with a simple and compact configuration, (i) easily adjusting a ratio between a quantity of light in the blue region and a quantity of light in the red region and (ii) emitting mixed-color light of blue light and red light with little spatial uneven color.

Further, the light emitting apparatus 10 of substrate-type is preferably arranged such that the ratio between (i) the photosynthetic photon flux in the blue region ranging from 400 nm to 480 nm and (ii) the photosynthetic photon flux in the red region ranging from 620 nm to 700 nm falls within a ratio of 1 : 1.3 to 1 : 10. This makes it possible to cause the light emitting apparatus 10 of substrate-type to be suitable for germination, nursery, and maturation of a plant.

Further, according to the light emitting apparatus 10 of substrate-type, the compound ratio (weight ratio), in the resin layer 7, between the resin 7a and the red phosphors 7b falls within a ratio of 1 : 0.05 to 1 : 0.20. This makes it possible to cause the light emitting apparatus 10 of substrate-type to be suitable for germination, nursery, and maturation of a plant.

In a case where it is intended that the light emitting apparatus 10 of substrate-type is provided on a germination shelf or a nursery shelf, it is preferable that the compound ratio (weight ratio), in the resin layer 7, between the resin 7a and the red phosphors 7b falls within a ratio of 1 : 0.05 to 1 : 0.10.

That is, chlorophyll, which plays a main role in photosynthesis of a plant, does not uniformly absorb light. Chlorophyll has clear absorption peaks near a wavelength of 660 nm in the red region and near a wavelength of 450 nm in the blue region. In association with such absorption peaks, a wavelength characteristic required for photosynthesis has a first peak near a wavelength of 660 nm and a second peak near a wavelength of 450 nm.

That is, at the maturation stage at which a plant grows to have a leaf and becomes active in photosynthesis, light having both blue and red optical elements is effective for growth of the plant. Meanwhile, blue light having a wavelength of near 450 nm also affects light reaction of plants called high-energy reaction system and is, accordingly, essential for healthy morphogenesis of a plant. Therefore, at the germination and nursery stage, the blue optical element increases in importance.

In this regard, according to the premised technique, the compound ratio (weight ratio), in the resin layer 7, between the resin 7a and the red phosphors 7b falls within a ratio of 1 : 0.05 to 1 : 0.10. Such a compound ratio (weight ratio) makes it possible to provide a light emitting apparatus 10 of substrate-type which easily emits light having a blue optical element essential for healthy morphogenesis of a plant at the germination and nursery stage.

Alternatively, in a case where it is intended that the light emitting apparatus 10 of substrate-type is provided on a maturation shelf, the light emitting apparatus 10 of substrate-type is arranged such that the compound ratio (weight ratio), in the resin layer 7, between the resin 7a and the red phosphors 7b falls within a ratio of 1 : 0.15 to 1 : 0.20. Such a compound ratio (weight ratio) makes it possible to provide a LED light source 10 of substrate-type which easily emits light having both blue and red optical elements at the maturation stage at which a plant grows to have a leaf and becomes active in photosynthesis.

Further, in a case where it is intended that the light emitting apparatus 10 of substrate-type is provided on the germination shelf or the nursery shelf, it is preferable that the light emitting apparatus 10 of substrate-type is arranged such that the ratio between (i) the photosynthetic photon flux in the blue region ranging from 400 nm to 480 nm and (ii) the photosynthetic photon flux in the red region ranging from 620 nm to 700 nm falls within a ratio of 1 : 1.3 to 1 : 3.5. This makes it possible to cause the light emitting apparatus 10 of substrate-type to be suitable for germination and nursery of a plant.

Alternatively, in a case where it is intended that the light emitting apparatus 10 of substrate-type is provided on the maturation shelf, it is preferable that the light emitting apparatus 10 of substrate-type is arranged such that the ratio between (i) the photosynthetic photon flux in the blue region ranging from 400 nm to 480 nm and (ii) the photosynthetic photon flux in the red region ranging from 620 nm to 700 nm falls within a ratio of 1 : 7.5 to 1 : 10. This makes it possible to cause the light emitting apparatus 10 of substrate-type to be suitable for maturation of a plant.

Further, the light emitting apparatus 10 of substrate-type is preferably arranged such that, for cultivation of a plant containing more chlorophyll a than chlorophyll b, the red phosphors 7b each contain CaAlSiN₃:Eu components.

Specifically, plants contain chlorophyll a and chlorophyll b. The chlorophyll a and chlorophyll b have respective different light absorption characteristics. More specifically, chlorophyll a has an absorption peak falling within a wavelength range of 650 nm to 660 nm in the red region, whereas chlorophyll b has an absorption peak falling within a wavelength range of 620 nm to 630 nm in the red region.

In view of the circumstances, the light emitting apparatus 10 of substrate-type is arranged such that, for cultivation of a plant containing more chlorophyll a than chlorophyll b, the red phosphors 7b each contain CaAlSiN₃:Eu components. That is, a red phosphor containing the CaAlSiN₃:Eu components is capable of emitting light having an emission peak wavelength falling within a range of 650 nm to 660 nm.

Therefore, for cultivating a plant containing more chlorophyll a than chlorophyll b, it is preferable to use red phosphors 7b each containing CaAlSiN₃:Eu components.

Further, the light apparatus 10 of substrate-type is preferably arranged such that, for cultivation of a plant containing more chlorophyll b than chlorophyll a, the red phosphors 7b each contain (Sr,Ca)AlSiN₃:Eu components.

That is, chlorophyll b has the absorption peak falling within a wavelength range of 620 nm to 630 nm in the red region, and a red phosphor containing (Sr,Ca)AlSiN3:Eu components is capable of emitting light having an emission peak wavelength falling within a range of 620 nm to 630 nm.

Therefore, for cultivating a plant containing more chlorophyll b than chlorophyll a, it is preferable to use red phosphors 7b each containing (Sr,Ca)AlSiN3:Eu components.

Further, the light emitting apparatus 10 of substrate-type is configured such that (i) the plurality of blue LED chips 2 are provided on the substrate 1, (ii) the resin dam 3 is provided so as to surround the plurality of blue LED chips 2, and (iii) the resin 7a in which the red phosphors 7b are dispersed is provided so as to fill inside of the resin dam 3.

It is therefore possible to emit a large quantity of light with the use of a single light emitting apparatus 10 of substrate-type occupying only a small area.

Further, the light emitting apparatus 10 of substrate-type is configured to emit (i) blue light having a wavelength of 400 nm to 480 nm and (ii) red light having a wavelength of 620 nm to 700 nm.

This makes it possible to achieve both blue and red peaks necessary for growth of a plant, with the use of a single LED light source 10 of substrate-type. Since a single light emitting apparatus 10 of substrate-type is capable of producing both blue and red peaks, the light emitting apparatus 10 of substrate-type allows (i) a reduction in area which the light emitting apparatus 10 of substrate-type occupies, (ii) an increase in reliability, and (iii) an increase in suitability for the use in a plant factory etc.

Furthermore, according to the light emitting apparatus 10 of substrate-type, the blue light is emitted from the blue LED chips 2, and the red light is emitted from the red phosphors 7b. That is, according to the light emitting apparatus 10 of substrate-type, the optical absorption peaks of the light absorption characteristics of chlorophyll are achieved in the vicinity of a light emitting section. Therefore, the blue light and the red light are uniformly emitted from the light emitting apparatus 10 of substrate-type. That is, according to the light emitting apparatus 10 of substrate-type, the optical absorption peaks of the light absorption characteristics of chlorophyll are achieved in the vicinity of a light emitting section. Therefore, the blue light and the red light are uniformly emitted from the light emitting apparatus 10 of substrate-type.

Specifically, part of the blue light emitted from the blue LED chips 2 is absorbed and converted to the red light by the red phosphors 7b, and the other of the blue light is scattered by the red phosphors 7b. In addition, since a particle of each of the red phosphors 7b is a point light source, blue light or red light is uniformly emitted.

This makes it possible to achieve both blue and red peaks necessary for growth of a plant, with the use of a single light emitting apparatus 10 of substrate-type. Such a single light emitting apparatus 10 of substrate-type allows (i) a reduction in area which the light emitting apparatus 10 of substrate-type occupies, (ii) an increase in reliability, and (iii) an increase in suitability for the use in a plant factory etc.

Further, the plant factory 30 using the premised technique includes: the light emitting apparatus 10A of substrate-type and/or the light emitting apparatus 10B of substrate-type; and the light emitting apparatus 10C of substrate-type and/or the light emitting apparatus 10D of substrate-type.

Accordingly, it is possible to provide a plant factory 30 including a light emitting apparatus 10 of substrate-type capable of, with a simple and compact configuration, easily adjusting a ratio between a quantity of light in the blue region and a quantity of light in the red region.

For example, according to (a) and (b) of Fig. 5, nothing is provided on a back surface of the substrate 1. Note, however, that this does not imply any limitation. Alternatively, for example, a finned heat sink can be further provided on the back surface of the substrate 1 which also serves as a heat radiation plate for the LED light source 10 of substrate-type. That is, the finned heat sink can be provided on a surface opposite to a surface on which the blue LED chips 2 are provided. This allows the substrate 1 to be cooled down by the finned heat sink when air flow is used in a room of a plant factory. Note that, in this case, it is preferable that an opening of the finned heat sink is set to be pointed in a direction of the air flow.

Alternatively, a tube through which a nutrient solution flows can be provided on the back surface of the substrate 1. That is, for example, a nutrient solution for culture and cultivation of a living thing can be used to cool down the substrate 1 and is then used to culture and cultivate the living thing. This makes it possible to suitably cool down the LED light source 10 of substrate-type, and it is therefore possible to stably emit blue light and red light which matches the optical absorption peaks of the light absorption characteristics of chlorophyll.

As described above, the light emitting apparatus 10 of substrate-type is preferably configured such that a finned heat sink, which serves as cooling means, is provided on the back surface of the substrate 1.

This makes it possible to cool down the blue LED chips 2 whose temperatures have increased.

### (Blue-complex-type light emitting apparatus)

The following description will discuss, with reference to Fig. 13, a blue-complex-type light emitting apparatus.

The light emitting apparatus 10 of substrate-type includes at least one blue LED chip which has an emission peak falling within a wavelength range of 400 nm to 480 nm so as to match the absorption peak in the blue region of chlorophyll.

On the other hand, the blue-complex-type light emitting apparatus is different from the other light emitting apparatuses in that blue LED chips are constituted by (i) at least one blue LED chip for chlorophyll a which blue LED chip has an emission peak falling within a wavelength range of 400 nm to 450 nm so as to match the absorption peak in the blue region of chlorophyll a and (ii) at least one blue LED chip for chlorophyll b which blue LED chip has an emission peak falling within a wavelength range of 400 nm to 480 nm so as to match the absorption peak in the blue region of chlorophyll b.

Specifically, a light emitting apparatus 50 of substrate-type, serving as a light emitting apparatus for plant cultivation, is constituted by (i) a substrate 1, (ii) a plurality of blue LED chips 2 and a plurality of blue LED chips 52 provided on the substrate 1, and (iii) a resin dam 3 which is made of resin and surrounds the blue LED chips 2 and 52 (see (a) of Fig. 13).

As illustrated in (b) of Fig. 13, inside the resin dam 3, each of the blue LED chips 2 and the blue LED chips 52 arranged in line is connected, via wires 5 which are electrically conductive, to wires 4a and 4b provided at both sides of the line. The wires 4a and 4b are connected to a cathode electrode land 6a and an anode electrode land 6b, respectively, each of which is provided on the substrate 1 and outside the resin dam 3.

Inside the resin dam 3, a resin layer 7 is provided which covers an upper part of each of the blue LED chips 2 and the blue LED chips 52 (see (b) of Fig. 13). The resin layer 7 is made up of (i) a resin 7a which fills inside of the resin dam 3 and (ii) red phosphors 7b mixed and dispersed in the resin 7a.

Each of the blue LED chips 2 emits blue light having a wavelength falling within a range of 400 nm to 480 nm in the blue region (long wavelengths in the blue region), which light matches the absorption peak in the blue region of chlorophyll b. That is, each of the blue LED chips 2 for the long wavelengths in the blue region serves as a blue LED chip for chlorophyll b of the present invention.

On the other hand, each of the blue LED chips 52 emits blue light having a wavelength falling within a range of 400 nm to 450 nm in the blue region (short wavelengths in the blue region), which light matches the absorption peak in the blue region of chlorophyll a. That is, each of the blue LED chips 52 for the short wavelengths in the blue region serves as a blue LED chip for chlorophyll a of the present invention.

Further, each of the red phosphors 7b emits, upon absorbing light from the blue LED chips 2 and light from the blue LED chips 52, red light having an emission peak falling within a wavelength range of 620 nm to 700 nm which matches the absorption peaks in the red region of chlorophyll a and chlorophyll b.

Specifically, plants contain chlorophyll a and chlorophyll b. The chlorophyll a and chlorophyll b have respective different light absorption characteristics in the blue region. More specifically, as illustrated in in Fig. 8 described above, chlorophyll a has the absorption peak falling within a wavelength range of 400 nm to 450 nm in the blue region, whereas chlorophyll b has the absorption peak falling within a wavelength range of 400 nm to 480 nm in the blue region.

In view of the circumstances, the light emitting apparatus 50 of substrate-type, serving as a light emitting apparatus for plant cultivation, is configured such that the blue LED chips are constituted by (i) at least one blue LED chip 52 (blue LED chip for chlorophyll a) for the short wavelengths in the blue region, which has an emission peak falling within a wavelength range of 400 nm to 450 nm so as to match the absorption peak in the blue region of chlorophyll a and (ii) at least one blue LED chip 2 (blue LED chip for chlorophyll b) for the long wavelengths in the blue region, which has an emission peak falling within a wavelength range of 400 nm to 480 nm so as to match the absorption peak in the blue region of chlorophyll b.

This makes it possible to provide an LED light source for plant cultivation which is more suitable for a plant containing chlorophyll a and chlorophyll b.

Note that the foregoing description has discussed the LED light source 50 of substrate-type, serving as an LED light source for plant cultivation, which is partly different in configuration from the LED light source 10 of substrate-type. Note, however, that the LED light source for plant cultivation of the present invention is not limited to this configuration. A bullet-shaped LED lamp partly different in configuration from a bullet-shaped LED lamp 40 to be described in the following Comparative Technique can be also employed.

### [Comparative Technique]

The following description will discuss, with reference to Fig. 12, a comparative technique. Note that configurations other than those described in Comparative Technique are identical to those described in Premised Technique.

### (Configuration of light emitting apparatus of comparative technique)

Each of the light emitting apparatus 10 of substrate-type and the light emitting apparatus 20 for illumination described in Premised Technique includes (i) a substrate 1 and (ii) at least one blue LED chip 2 provided on the substrate 1. However, as illustrated in (a) and (b) of Fig. 12, a light emitting apparatus for plant cultivation using the comparative technique is different from the light emitting apparatus 10 of substrate-type and the light emitting apparatus 20 in that the light emitting apparatus has a typical bullet shape.

The following description will discuss, with reference to (a) and (b) of Fig. 12, a configuration of the light emitting apparatus for plant cultivation using the comparative technique. (a) and (b) of Fig. 12 are each a cross-sectional view schematically illustrating a configuration of a bullet-shaped LED lamp.

As illustrated in (a) and (b) of Fig. 12, a bullet-shaped LED lamp 40 using the comparative technique, which LED lamp 40 serves as a light emitting apparatus for plant cultivation, includes (i) a mount lead cup (cup) 41, (ii) a blue LED chip 2 bonded in the mount lead cup 41, (iii) a resin layer 7 constituted by red phosphors 7b and a resin 7a made of silicone resin, (iv) wires 5 which are electrically conductive (conductive wires), (v) an anode lead frame 42 (anode lead), (vi) a cathode lead frame 43 (cathode lead), and (vii) a sealing resin 44 made of epoxy resin, which sealing resin 44 has a shape of a bullet and encloses all the members except an end of the anode lead frame 42 and an end of the cathode lead frame 43. Each of the red phosphors 7b used here can be a CaAlSiN₃:Eu phosphor, for example.

The bullet-shaped LED lamp 40 is produced in the following manner. The blue LED chip 2 is bonded in the mount lead cup 41. Next, (i) the blue LED chip 2 and a mount lead (not illustrated) are electrically connected via a wire 5 and (ii) the blue LED chip 2 and an inner lead (not illustrated) are electrically connected via another wire 5. After that, the red phosphors 7b are mixed into and dispersed in the resin 7a, and the resin 7a is poured into the mount lead cup 41 to form the resin layer 7. As a result, the resin layer 7 covers and fixes the blue LED chip 2. Lastly, all the members are covered and protected by the sealing resin 44 (mold member) made of epoxy resin.

According to the bullet-shaped LED lamp 40, the blue LED chip 2 emits blue light having a wavelength falling within a range of 400 nm to 480 nm. The blue light matches an absorption peak in a blue region of chlorophyll. On the other hand, the red phosphors 7b emit, upon absorbing the light from the blue LED chip 2, red light having an emission peak falling within a wavelength range of 620 nm to 700 nm. The red light matches an absorption peak in a red region of chlorophyll.

According to the comparative technique, the bullet-shaped LED lamp 40 as illustrated in (a) of Fig. 12 is a bullet-shaped LED lamp 40A in which the compound ratio between the resin 7a and the red phosphors 7b is 1 : 0.05. The bullet-shaped LED lamp 40A is configured to emit light having a spectrum identical to that (see (a) of Fig. 7) of the LED light source 10A of substrate-type.

Therefore, the bullet-shaped LED lamp 40A matches the absorption peak in the blue region of chlorophyll, and is preferably used for germination and nursery. Note, however, that this does not imply any limitation. The bullet-shaped LED lamp 40 can also be configured such that the compound ratio between the resin 7a and the red phosphors 7b falls within a ratio of 1 : 0.10 to 1 : 0.15.

On the other hand, the bullet-shaped LED lamp 40 as illustrated in (b) of Fig. 12 is a bullet-shaped LED lamp 40D in which the compound ratio between the resin 7a and the red phosphors 7b is 1 : 0.20. That is, the bullet-shaped LED lamp 40D is configured to emit light having a spectrum identical to that (see (b) of Fig. 7) of the light emitting apparatus 10D of substrate-type. As such, the bullet-shaped LED lamp 40D matches the absorption peak in the red region of chlorophyll, and is preferably used for maturation.

Such a bullet-shaped LED lamp 40 is attached to a position where it is difficult to attach the light emitting apparatus 10 of substrate-type, which is constituted by the substrate 1 and the blue LED chips 2 provided on the substrate 1 (described in Premised Technique). Note, however, that there are not so many places where it is difficult to attach the light emitting apparatus 10 of substrate-type. Therefore, the light emitting apparatus 10 of substrate-type and the bullet-shaped LED lamp 40 can be used in combination.

Lastly, Table 1 shows a comparison of (i) the light emitting apparatus 10 of substrate-type, (ii) the bullet-shaped LED lamp 40, and (iii) a combination of a conventional bullet-shaped red LED lamp and a conventional bullet-shaped blue LED lamp. Note that the conventional bullet-shaped red LED lamp is a light emitting apparatus manufactured in accordance with "Description of Embodiments" and Figs. 1 and 2 of Patent Literature 2.

**[Table 1]**

| | Premised Technique | Comparative Technique | Conventional example |
|---|---|---|---|
| | Light emitting apparatus of substrate-type | Bullet-shaped LED lamp | Bullet-shaped red LED lamp and bullet-shaped blue LED lamp |
| Material | • Ceramic | • Epoxy resin | • Epoxy resin |
| | • Silicone resin | • Silicone resin | |
| Reliability | • Reliability is improved because no epoxy resin is used and thus there is a less deterioration in resin | • Reliability is improved because short-wavelength component (cause of deterioration) is converted into red component | Depends on the life of red LED chip |
| | | | • Transmittance of resin decreases due to short-wavelength light |
| | • Processing cost is reduced due to good chromaticity achieved by controlling a ratio of resin to red phosphor | | |
| Cost | Packaging cost is reduced because only a single type of LED chip (blue LED chip) is used and thus the LED chip can be packed into a single package by a high-density packaging technique | • Cost is reduced because red phosphor is used in place of red LED chip | • Red LED chip is expensive |
| | • Cost is reduced because red phosphor is used in place of red LED chip | | |
| Characteristics | Temperature characteristic is improved (by approximately 10%) because no red LED chip is used | • Temperature characteristic is improved (by approximately 10%) because no red LED chip is used | • Temperature characteristic of red LED chip is not good |
| Installation area | • 1/6 (assuming that a conventional example is 1) | • 1/3 (assuming that a conventional example is 1) | • 1 |
| Life | • 40,000 hours at an ambient temperature of 50°C | • 15,000 hours at an ambient temperature of 50°C | • 5,000 hours at an ambient temperature of 50°C |

As is clear from Table 1, the light emitting apparatus 10 of substrate-type and the bullet-shaped LED lamp 40 are superior to the combination of the conventional bullet-shaped red LED lamp and the conventional bullet-shaped blue LED lamp in terms of all of the following points: reliability, cost, characteristics, installation area and life.

Specifically, with regard to the installation area, assuming that a combination of a bullet-shaped blue LED and a bullet-shaped red LED (conventional technique) occupies an area of 1, the bullet-shaped LED lamp 40 occupies an area of 1/3 and the LED light source 10 of substrate-type and the LED light source 20 for illumination each occupy an area of 1/6. That is, the light emitting apparatus 10 of substrate-type, the light emitting apparatus 20 for illumination, and the bullet-shaped LED lamp 40 are advantageous in that each of them occupies only a small area.

Further, with regard to costs, the light emitting apparatus 10 of substrate-type, the light emitting apparatus 20 for illumination, and the bullet-shaped LED lamp 40 are clearly more cost effective than the conventional techniques.

Furthermore, the light emitting apparatus 10 of substrate-type and the light emitting apparatus 20 for illumination last for 30,000 to 40,000 hours. It is needless to say that this is longer than the life of an electric lamp (bulb), and is 10 times or more as long as the life of a fluorescent lamp.

As described above, the bullet-shaped LED lamp 40, serving as a light emitting apparatus for plant cultivation, includes (i) the cathode lead frame 43, (ii) the mount lead cup 41 connected to the cathode lead frame 43, (iii) at least one blue LED chip 2 provided in the mount lead cup 41, (iv) the anode lead frame 42 connected, via the wire 5, to the at least one blue LED chip 2 provided in the mount lead cup 41, (v) the resin layer 7 in which the red phosphors 7b are dispersed and with which the mount lead cup 41 is filled so that the at least one blue LED chip 2 is covered, and (vi) the sealing resin 44 which has a bullet shape and encloses the entire mount lead cup 41 such that the end of the cathode lead frame 43 and the end of the anode lead frame 42 are exposed.

This makes it possible to provide a bullet-shaped LED lamp 40 having a so-called bullet shape. Since such a bullet-shaped LED lamp 40 having a bullet shape occupies only a small area, the bullet-shaped LED lamp 40 is suitable for spotlighting for plant cultivation.

The light emitting apparatus of the present invention is preferably arranged such that the at least one first blue LED chip and the at least one second blue LED chip each emit light having an emission peak wavelength which falls within a range of 400 nm to 480 nm; and the red phosphor emits light having an emission peak wavelength which falls within a range of 620 nm to 700 nm.

It is known that chlorophyll, which absorbs light necessary for a living thing to carry out photosynthesis, has optical absorption peaks in a blue region (within a wavelength range of 400 nm to 480 nm) and in a red region (within a wavelength range of 620 nm to 700 nm).

According to the above configuration, the optical absorption peak in the blue region of chlorophyll matches the emission peak of light emitted from the blue LED chip, whereas the optical absorption peak in the red region of chlorophyll corresponds to the emission peak of light emitted from the red phosphor upon receipt of excitation light from the blue LED chip. It is therefore possible to provide a light emitting apparatus capable of more effectively cultivating or culturing a specific living thing.

The light emitting apparatus of the present invention is arranged such that the emission peak wavelength of light emitted from the at least one first blue LED chip provided in the first light emitting section is different from that of light emitted from the at least one second blue LED chip provided in the second light emitting section.

Chlorophyll a and chlorophyll b are each known as a kind of chlorophyll, which (i) are often seen in, for example, plants and some of algae and (ii) have respective different optical absorption characteristics. Specifically, chlorophyll a has an optical absorption peak falling within a wavelength range of 430 nm to 440 nm, whereas chlorophyll b has an optical absorption peak falling within a wavelength range of 450 nm to 460 nm.

According to the above configuration, it is possible to independently control a quantity of light from the first light emitting section and a quantity of light from the second light emitting section. This makes it possible to control, as appropriate, light so as to have a quantity suitable for a specific target living thing which has various ratios between chlorophyll a and chlorophyll b. It is therefore possible to provide a light emitting apparatus which emits an optical element more suitable for the specific target living thing.

Obviously, such a compound that absorbs light necessary for a living thing to carry out photosynthesis is not limited to chlorophyll a and chlorophyll b, and includes various compounds. Therefore, it is necessary to select a blue LED chip as appropriate in accordance with a compound.

The light emitting apparatus of the present invention is preferably arranged such that a ratio, between photosynthetic photon flux falling within a wavelength range of 400 nm to 480 nm (blue region) and photosynthetic photon flux falling within a wavelength range of 620 nm to 700 nm (red region), is 1 : 1.3 to 1 : 10.

In general, in a case of using the photon flux density, the number of photons is counted. Therefore, the number to be counted is the same both in a case of infrared light and in a case of ultraviolet light. On the other hand, a photochemical reaction occurs only when photons that a pigment can absorb are received. As such, for example, receiving light that chlorophyll cannot absorb means nothing to plants. In view of the circumstances, in the field of photosynthesis, "photosynthetic photon flux density" and "photosynthetic photon flux" are defined only for light whose wavelength ranges from 400 nm to 700 nm which light chlorophyll can absorb.

According to the above configuration, it is possible to provide a light emitting apparatus suitable for germination, nursery, and maturation of a plant, or for culture of specific algae or bacteria.

The light emitting apparatus of the present invention is preferably arranged such that the red phosphor has (Sr,Ca)AlSiN3:Eu components and/or CaAlSiN₃:Eu components.

An emission peak of each of CaAlSiN₃:Eu phosphors, which peak falls within a wavelength range of 620 nm to 660 nm, matches the optical absorption peak of chlorophyll a, which peak falls within a wavelength range of 650 nm to 660 nm in the red region. An emission peak of each of (Sr,Ca)AlSiN₃:Eu phosphors, which peak falls within a wavelength range of 620 nm to 630 nm, matches the optical absorption peak of chlorophyll b, which peak falls within a wavelength range of 620 nm to 630 nm in the red region.

Therefore, according to the above configuration, it is possible to emit light having an emission peak which matches the optical absorption peaks in the red region of chlorophyll a and chlorophyll b which are often seen in plants or algae. It is therefore possible to provide a light emitting apparatus suitable for cultivation or culture of a plant or algae containing a large amount of chlorophyll a or chlorophyll b.

The light emitting apparatus of the present invention is preferably arranged such that the at least one first blue LED chip and the at least one second blue LED chip are each at least one of (i) a blue LED chip which emits light having an emission peak wavelength which falls within a range of 430 nm to 440 nm and (ii) a blue LED chip which emits light having an emission peak wavelength which falls within a range of 450 nm to 460 nm.

According to the above configuration, by providing two types of blue LED chips, it is possible to provide a light emitting apparatus capable of emitting light having an optical element suitable for a specific target living thing having a certain ratio between chlorophyll a and chlorophyll b.

The light emitting apparatus of the present invention further includes: a resin wall provided so as to enclose a region in which the at least one first blue LED chip and the at least one second blue LED chip are provided, part of the region, enclosed by the resin wall in which part the first light emitting section is provided, being filled with the resin in which the red phosphor is dispersed, part of the region, enclosed by the resin wall in which part the second light emitting section is provided, being filled with a light-permeable resin which seals the at least one second blue LED chip. With this, it is possible to suitably form light emitting sections as a light emitting apparatus of substrate-type.

The light emitting apparatus of the present invention is preferably arranged such that a finned heat sink is provided on a surface of the substrate which surface is opposite to a surface on which the first and second light emitting sections are provided.

With the configuration, it is possible to effectively cool down the substrate by the finned heat sink when air flow is used in a room in which the light emitting apparatus is provided. Further, by effectively cooling down the substrate, emission characteristics of the blue LED chip and the red phosphor are stabilized. It is therefore possible to stabilize composition of red and blue light.

The light emitting apparatus of the present invention is preferably arranged such that a tube through which a nutrient solution flows is provided on a surface of the substrate which surface is opposite to a surface on which the first and second light emitting sections are provided.

With the configuration, it is possible to effectively cool down the light emitting apparatus. Further, by effectively cooling down the light emitting apparatus, emission characteristics of the blue LED chip and the red phosphor are stabilized. It is therefore possible to emit red and blue light stable in composition.

The method of manufacturing a light emitting apparatus of the present invention further includes, between the bonding step and the phosphor-containing resin layer forming step, the steps of: (i) forming a resin wall so as to enclose the first region and the second region; and (ii) in the second light emitting section, sealing, with a light-permeable resin, the at least one of the plurality of blue LED chips which one is provided in the second region, in the phosphor-containing resin layer forming step, the first region enclosed by the resin wall being filled with the resin in which the red phosphor is dispersed so that the resin covers the at least one of the plurality of blue LED chips which one is provided in the first region, in the sealing step with a light-permeable resin, the second region enclosed by the resin wall being filled with the light-permeable resin so that the light-permeable resin covers the at least one of the plurality of blue LED chips which one is provided in the second region.

According to the above method, it is possible to use, as the resin layer, a resin which is low in viscosity, and thus possible to form the resin layer more effectively.

According to the method of manufacturing a light emitting apparatus of the present invention, the phosphor-containing resin layer is made of silicone resin: and the silicone resin of the phosphor-containing resin layer of the first light emitting section is a resin which has high thixotropy and does not have flowability.

According to the above method, use of silicone resin causes a less deterioration in resin and, accordingly, allows an increase in reliability, as compared with conventional epoxy resin. Further, the silicone resin of the resin layer of the first light emitting section is a resin which is high in thixotropy and does not have flowability. It is therefore possible to easily form the resin layer in the mixed light emitting section without forming a resin wall between the first and the second light emitting sections. Further, forming no resin wall between the first and the second light emitting sections allows an increase in areas of the first and second light emitting sections. It is therefore possible to provide a light emitting apparatus capable of effectively emitting light.

### Industrial Applicability

The present invention can be used as a light emitting apparatus employing a plurality of LEDs or a light emitting apparatus used to cultivate or culture a photosynthetic living thing. Further, the present invention can be used by (i) a plant factory for growing a plant, (ii) a culturing factory for culturing photosynthetic algae or bacteria, and (iii) cosmetic manufacturer, food manufacturer, or medical supply manufacturer each of which requires a compound obtained from a photosynthetic plant, algae, or bacteria.

### Reference Signs List

- 100: Light emitting apparatus (spiral)
- 1, 101: Substrate
- 102: Blue LED chips (light emitting elements)
- 105: First resin dam (resin wall)
- 106: Second resin dam (resin wall)
- 107: Phosphor-containing resin layer
- 108: Light-permeable resin layer
- 7b, 109: Red phosphors
- 110 to 113: Electrode lands
- 200: Light emitting apparatus (horizontal-striped)
- 300: Light emitting apparatus (crossed)
- 400: Light emitting apparatus (double circular)

## Claims

1. A light emitting apparatus (100, 200, 300, 400, 10, 10A, 10B, 50, 40) comprising:
a substrate (101); and
first and second light emitting sections provided on the substrate so as to be adjacent to each other, the first light emitting section emitting red light, the second light emitting section emitting blue light,
the light emitting apparatus (100, 200, 300, 400, 10, 10A, 10B, 50, 40) emitting mixed-color light of the red light emitted from the first light emitting section and the blue light emitted from the second light emitting section,
the first light emitting section being made up of (i) at least one first blue LED chip (102, 2, 52) which emits blue light and (ii) a resin which covers the at least one first blue LED chip and in which a red phosphor (109, 7b) is dispersed that emits red light upon receipt of excitation light from the at least one first blue LED chip,
the second light emitting section being made up of at least one second blue LED chip (102, 2, 52) which emits blue light, **characterized in that**
the light emitting apparatus (100, 200, 300, 400, 10, 10A, 10B, 50, 40) is configured to be used for plant cultivation and **in that** the at least one first blue LED chip (102, 2, 52), which constitutes the first light emitting section, is different in emission peak wavelength from the at least one second blue LED chip (102, 2, 52), which constitutes the second light emitting section.

2. The light emitting apparatus (100, 200, 300, 400, 10, 10A, 10B, 50, 40) for plant cultivation as set forth in claim 1, wherein:
the at least one first blue LED chip (102, 2, 52) and the at least one second blue LED chip (102, 2, 52) each emit light having an emission peak wavelength which falls within a range of 400 nm to 480 nm; and
the red phosphor (109, 7b) emits light having an emission peak wavelength which falls within a range of 620 nm to 700 nm.

3. The light emitting apparatus (100, 200, 300, 400, 10, 10A, 10B, 50, 40) for plant cultivation as set forth in any one of claims 1 or 2 , wherein a ratio, between photosynthetic photon flux falling within a wavelength range of 400 nm to 480 nm (blue region) and photosynthetic photon flux falling within a wavelength range of 620 nm to 700 nm (red region), is 1 : 1.3 to 1 : 10.

4. The light emitting apparatus (100, 200, 300, 400, 10, 10A, 10B, 50, 40) for plant cultivation as set forth in any one of claims 1 through 3, the red phosphor (109, 7b) has (Sr,Ca)AlSiN₃:Eu components and/or CaAlSiN₃:Eu components.

5. The light emitting apparatus (100, 200, 300, 400, 10, 10A, 10B, 50, 40) for plant cultivation as set forth in claim 1, wherein
the at least one first blue LED chip (102, 2, 52) and the at least one second blue LED chip (102, 2, 52) are each at least one of (i) a blue LED chip which emits light having an emission peak wavelength which falls within a range of 430 nm to 440 nm and (ii) a blue LED chip which emits light having an emission peak wavelength which falls within a range of 450 nm to 460 nm.

6. A light emitting apparatus (100, 200, 300, 400) for plant cultivation as set forth in claim 1, further comprising:
a resin wall (106) provided so as to enclose a region in which the at least one first blue LED chip and the at least one second blue LED chip are provided,
part of the region, enclosed by the resin wall (106) in which part the first light emitting section is provided, being filled with the resin (108) in which the red phosphor (109, 7b) is dispersed,
part of the region, enclosed by the resin wall (106) in which part the second light emitting section is provided, being filled with a light-permeable resin (108) which seals the at least one second blue LED chip.

7. The light emitting apparatus (100, 200, 300, 400, 10, 10A, 10B, 50, 40) for plant cultivation as set forth in claim 1, wherein a finned heat sink is provided on a surface of the substrate which surface is opposite to a surface on which the first and second light emitting sections are provided.

8. The light emitting apparatus (100, 200, 300, 400, 10, 10A, 10B, 50, 40) for plant cultivation as set forth in claim 1, wherein a tube is provided on a surface of the substrate which surface is opposite to a surface on which the first and second light emitting sections are provided.

9. A method of manufacturing a light emitting apparatus (100, 200, 300, 400, 10, 10A, 10B, 50, 40) comprising the steps of:
(a) bonding, to a substrate (101), a plurality of blue LED chips (102, 2, 52) each of which emits blue light; and
(b) forming a phosphor-containing resin layer (107), which constitutes a first light emitting section which emits red light, in a first region on the substrate so that the phosphor-containing resin layer seals, with a resin, at least one of the plurality of blue LED chips (102, 2, 52) which one is provided in the first region, in which resin a red phosphor (109, 7b) is dispersed that emits red light upon receipt of excitation light from the at least one of the plurality of blue LED chips (102, 2, 52),
wherein a light emitting section, made up of at least one of the plurality of blue LED chips (102, 2, 52) which one is provided in a second region adjacent to the first region on the substrate, serves as a second light emitting section which emits blue light, **characterized in that**
the light emitting apparatus (100, 200, 300, 400, 10, 10A, 10B, 50, 40) is configured to be used for plant cultivation and
the at least one of the plurality of blue LED chips (102, 2, 52), which constitutes the first light emitting section, is different in emission peak wavelength from the at least another one of the plurality of blue LED chips (102, 2, 52), which constitutes the second light emitting section.

10. A method of manufacturing a light emitting apparatus (100, 200, 300, 400, 10, 10A, 10B, 50, 40) as set forth in claim 9, further comprising, between the steps (a) and (b), the steps of:
(i) forming a resin wall (105, 106) so as to enclose the first region and the second region; and
(ii) in the second light emitting section, sealing, with a light-permeable resin (108), the at least one of the plurality of blue LED chips (102, 2, 52) which one is provided in the second region,
in the step (b), the first region enclosed by the resin wall being filled with the resin (107, 7a) in which the red phosphor (109, 7b) is dispersed so that the resin covers the at least one of the plurality of blue LED chips (102, 2, 52) which one is provided in the first region,
in the step (ii), the second region enclosed by the resin wall (105, 106) being filled with the light-permeable resin so that the light-permeable resin covers the at least one of the plurality of blue LED chips (102, 2, 52) which one is provided in the second region.

11. The method of manufacturing a light emitting apparatus (100, 200, 300, 400, 10, 10A, 10B, 50, 40) as set forth in claim 9, wherein:
the phosphor-containing resin layer (107, 7a) is made of silicone resin: and
the silicone resin of the phosphor-containing resin layer of the first light emitting section is a resin which is higher in thixotropy than that of the light-permeable resin (108) and does not have flowability.

## Patentansprüche

1. Lichtemittierende Vorrichtung (100, 200, 300, 400, 10, 10A, 10B, 50, 40), umfassend:
ein Substrat (101); und
erste und zweite lichtemittierende Sektionen, die auf dem Substrat so vorgesehen sind, dass sie einander benachbart sind, wobei die erste lichtemittierende Sektion rotes Licht emittiert, die zweite lichtemittierende Sektion blaues Licht emittiert,
wobei die lichtemittierende Vorrichtung (100, 200, 300, 400, 10, 10A, 10B, 50, 40) gemischtfarbiges Licht aus dem von der ersten lichtemittierenden Sektion emittierten roten Licht und dem von der zweiten lichtemittierenden Sektion emittierten blauen Licht emittiert,
wobei die erste lichtemittierende Sektion aus (i) zumindest einem ersten blauen LED-Chip (102, 2, 52), der blaues Licht emittiert, und (ii) einem Harz besteht, welches den zumindest einen ersten blauen LED-Chip bedeckt und in welchem ein roter Leuchtstoff (109, 7b) verteilt ist, der bei Empfang von Anregungslicht von dem zumindest einen ersten blauen LED-Chip rotes Licht emittiert,
wobei die zweite lichtemittierende Sektion aus zumindest einem zweiten blauen LED-Chip (102, 2, 52) besteht, welcher blaues Licht emittiert,
**dadurch gekennzeichnet, dass**
die lichtemittierende Vorrichtung (100, 200, 300, 400, 10, 10A, 10B, 50, 40) dafür eingerichtet ist, für Pflanzenanbau genutzt zu werden, und dadurch, dass der zumindest eine erste blaue LED-Chip (102, 2, 52), welcher die erste lichtemittierende Sektion bildet, in einer Emissionsspitzenwellenlänge von dem zumindest einen zweiten blauen LED-Chip (102, 2, 52) verschieden ist, welcher die zweite lichtemittierende Sektion bildet.

2. Lichtemittierende Vorrichtung (100, 200, 300, 400, 10, 10A, 10B, 50, 40) für Pflanzenanbau nach Anspruch 1, wobei:
der zumindest eine erste blaue LED-Chip (102, 2, 52) und der zumindest eine zweite blaue LED-Chip (102, 2, 52) jeweils Licht mit einer Emissionsspitzenwellenlänge emittieren, die in einen Bereich von 400 nm bis 480 nm fällt; und
der rote Leuchtstoff (109, 7b) Licht mit einer Emissionsspitzenwellenlänge emittiert, die in einen Bereich von 620 nm bis 700 nm fällt.

3. Lichtemittierende Vorrichtung (100, 200, 300, 400, 10, 10A, 10B, 50, 40) für Pflanzenanbau nach einem der Ansprüche 1 oder 2, wobei
ein Verhältnis zwischen einem photosynthetischen Photonenfluss, der in einen Wellenlängenbereich von 400 nm bis 480 nm (blauer Bereich) fällt, und einem photosynthetischen Photonenfluss, der in einen Wellenlängenbereich von 620 nm bis 700 nm (roter Bereich) fällt, 1 : 1,3 bis 1 : 10 beträgt.

4. Lichtemittierende Vorrichtung (100, 200, 300, 400, 10, 10A, 10B, 50, 40) für Pflanzenanbau nach einem der Ansprüche 1 bis 3, wobei
der rote Leuchtstoff (109, 7b) (Sr,Ca)AlSiN₃:Eu-Komponenten und/oder CaAlSiN₃:Eu-Komponenten aufweist.

5. Lichtemittierende Vorrichtung (100, 200, 300, 400, 10, 10A, 10B, 50, 40) für Pflanzenanbau nach Anspruch 1, wobei
der zumindest eine erste blaue LED-Chip (102, 2, 52) und der zumindest eine zweite blaue LED-Chip (102, 2, 52) jeweils zumindest einer (i) eines blauen LED-Chips, welcher Licht mit einer Emissionsspitzenwellenlänge emittiert, die in einen Bereich von 430 nm bis 440 nm fällt, und (ii) eines blauen LED-Chips sind, welcher Licht mit einer Emissionsspitzenwellenlänge emittiert, die in einen Bereich von 450 nm bis 460 nm fällt.

6. Lichtemittierende Vorrichtung (100, 200, 300, 400) für Pflanzenanbau nach Anspruch 1, ferner umfassend:
eine Harzwand (106), die so vorgesehen ist, dass sie einen Bereich umschließt, in welchem der zumindest eine erste blaue LED-Chip und der zumindest eine zweite blaue LED-Chip vorgesehen sind,
wobei ein Teil des Bereichs, der von der Harzwand (106) umschlossen wird, in welchem Teil die erste lichtemittierende Sektion vorgesehen ist, mit dem Harz (108) gefüllt ist, worin der rote Leuchtstoff (109, 7b) verteilt ist,
wobei ein Teil des Bereichs, der von der Harzwand (106) umschlossen ist, in welchem Teil die zweite lichtemittierende Sektion vorgesehen ist, mit einem lichtdurchlässigen Harz (108) gefüllt ist, welches den zumindest einen zweiten blauen LED-Chip versiegelt.

7. Lichtemittierende Vorrichtung (100, 200, 300, 400, 10, 10A, 10B, 50, 40) für Pflanzenanbau nach Anspruch 1, wobei
ein gerippter Kühlkörper auf einer Oberfläche des Substrats vorgesehen ist, welche Oberfläche einer Oberfläche gegenüberliegt, auf der die ersten und zweiten lichtemittierenden Sektionen vorgesehen sind.

8. Lichtemittierende Vorrichtung (100, 200, 300, 400, 10, 10A, 10B, 50, 40) für Pflanzenanbau nach Anspruch 1, wobei
ein Rohr auf einer Oberfläche des Substrats vorgesehen ist, welche Oberfläche einer Oberfläche gegenüberliegt, auf der die ersten und zweiten lichtemittierenden Sektionen vorgesehen sind.

9. Verfahren zum Herstellen einer lichtemittierenden Vorrichtung (100, 200, 300, 400, 10, 10A, 10B, 50, 40), mit den Schritten:
(a) Bonden, an ein Substrat (101), einer Vielzahl von blauen LED-Chips (102, 2, 52), von denen jeder blaues Licht emittiert; und
(b) Ausbilden einer leuchtstoffhaltigen Harzschicht (107), welche eine erste lichtemittierende Sektion bildet, welche rotes Licht emittiert, in einem ersten Bereich auf dem Substrat, so dass die leuchtstoffhaltige Harzschicht mit einem Harz zumindest einen der Vielzahl von blauen LED-Chips (102, 2, 52) versiegelt, welcher eine in dem ersten Bereich vorgesehen ist, in welchem Harz ein roter Leuchtstoff (109, 7b) verteilt ist, der bei Empfang von Anregungslicht von dem zumindest einen der Vielzahl von blauen LED-Chips (102, 2, 52) rotes Licht emittiert,
wobei eine lichtemittierende Sektion, die aus zumindest einem der Vielzahl von blauen LED-Chips (102, 2, 52) besteht, welcher eine in einem zweiten Bereich vorgesehen ist, der dem ersten Bereich auf dem Substrat benachbart ist, als eine zweite lichtemittierende Sektion dient, welche blaues Licht emittiert,
**dadurch gekennzeichnet, dass**
die lichtemittierende Vorrichtung (100, 200, 300, 400, 10, 10A, 10B, 50, 40) dafür eingerichtet ist, für Pflanzenanbau genutzt zu werden, und der zumindest eine der Vielzahl von blauen LED-Chips (102, 2, 52), welcher die erste lichtemittierende Sektion bildet, in einer Emissionsspitzenwellenlänge von dem zumindest anderen einen der Vielzahl von blauen LED-Chips (102, 2, 52) verschieden ist, welcher die zweite lichtemittierende Sektion bildet.

10. Verfahren zum Herstellen einer lichtemittierenden Vorrichtung (100, 200, 300, 400, 10, 10A, 10B, 50, 40) nach Anspruch 9, ferner umfassend, zwischen den Schritten (a) und (b), die Schritte:
(i) Ausbilden einer Harzwand (105, 106), so dass sie den ersten Bereich und den zweiten Bereich umschließt; und
(ii) in der zweiten lichtemittierenden Sektion, Versiegeln, mit einem lichtdurchlässigen Harz (108), des zumindest einen der Vielzahl von blauen LED-Chips (102, 2, 52), welcher eine in dem zweiten Bereich vorgesehen ist,
wobei im Schritt (b) der von der Harzwand umschlossene erste Bereich mit dem Harz (107, 7a) gefüllt wird, in welchem der rote Leuchtstoff (109, 7b) verteilt ist, so dass das Harz den zumindest einen der Vielzahl von blauen LED-Chips (102, 2, 52) bedeckt, welcher eine in dem ersten Bereich vorgesehen ist,
wobei im Schritt (ii) der von der Harzwand (105, 106) umschlossene zweite Bereich mit dem lichtdurchlässigen Harz gefüllt wird, so dass das lichtdurchlässige Harz den zumindest einen der Vielzahl von blauen LED-Chips (102, 2, 52) bedeckt, welcher eine in dem zweiten Bereich vorgesehen ist.

11. Verfahren zum Herstellen einer lichtemittierenden Vorrichtung (100, 200, 300, 400, 10, 10A, 10B, 50, 40) nach Anspruch 9, wobei
die leuchtstoffhaltige Harzschicht (107, 7a) aus Silikonharz besteht; und
das Silikonharz der leuchtstoffhaltigen Harzschicht der ersten lichtemittierenden Sektion ein Harz ist, welches eine höhere Thixotropie als diejenige des lichtdurchlässigen Harzes (108) aufweist und keine Fließfähigkeit aufweist.

## Revendications

1. Appareil émetteur de lumière (100, 200, 300, 400, 10, 10A, 10B, 50, 40) comprenant :
un substrat (101) ; et
des première et deuxième sections émettrices de lumière disposées sur le substrat de manière à être voisines l'une de l'autre, la première section émettrice de lumière émettant une lumière rouge, et la seconde section émettrice de lumière émettant une lumière bleue,
l'appareil émetteur de lumière (100, 200, 300, 400, 10, 10A, 10B, 50, 40) émettant une lumière de couleur mixte de la lumière rouge émise à partir de la première section émettrice de lumière et de la lumière bleue émise à partir de la deuxième section émettrice de lumière,
la première section émettrice de lumière étant composée (i) d'au moins une première puce LED bleue (102, 2, 52) qui émet une lumière bleue, et (ii) d'une résine qui couvre la ou les premières puces LED bleues et dans laquelle est dispersée une substance luminescente rouge (109, 7b) qui émet une lumière rouge lors de la réception d'une lumière d'excitation à partir de la ou des premières puces LED bleues,
la deuxième section émettrice de lumière étant composée d'au moins une deuxième puce à LED bleue (102, 2, 52) qui émet une lumière bleue,
**caractérisé en ce que** l'appareil émetteur de lumière (100, 200, 300, 400, 10, 10A, 10B, 50, 40) est conçu pour être utilisé pour la culture de plantes, et **en ce que** la ou les premières puces à LED bleues (102, 2, 52) qui constituent la première section émettrice de lumière ont une longueur d'onde de pointe d'émission différente de celle de la ou des deuxièmes puces à LED bleues (102, 2, 52) qui constituent la deuxième section émettrice de lumière.

2. Appareil émetteur de lumière (100, 200, 300, 400, 10, 10A, 10B, 50, 40) pour la culture de plantes tel qu'il est présenté dans la revendication 1, dans lequel :
la ou les premières puces à LED bleues (102, 2, 52) et la ou les deuxièmes puces à LED bleues (102, 2, 52) émettent chacune une lumière présentant une longueur d'onde de pointe d'émission qui est située dans une plage de 400 nm à 480 nm ; et
la substance luminescente rouge (109, 7b) émet une lumière présentant une longueur d'onde de pointe d'émission qui est située dans une plage de 620 nm à 700 nm.

3. Appareil émetteur de lumière (100, 200, 300, 400, 10, 10A, 10B, 50, 40) pour la culture de plantes tel qu'il est présenté dans l'une quelconque des revendications 1 ou 2, dans lequel un rapport entre un flux photonique photosynthétique situé dans une plage de longueur d'onde de 400 nm à 480 nm (zone bleue) et un flux photonique photosynthétique situé dans une plage de longueur d'onde de 620 nm à 700 nm (zone rouge) est de 1:1,3 à 1:10.

4. Appareil émetteur de lumière (100, 200, 300, 400, 10, 10A, 10B, 50, 40) pour la culture de plantes tel qu'il est présenté dans l'une quelconque des revendications 1 à 3, dans lequel la substance luminescente rouge (109, 7b) a des composants (Sr,Ca)AlSiN₃:Eu et/ou des composants CaAlSiN₃:Eu.

5. Appareil émetteur de lumière (100, 200, 300, 400, 10, 10A, 10B, 50, 40) pour la culture de plantes tel qu'il est présenté dans la revendication 1, dans lequel la ou les premières puces à LED bleues (102, 2, 52) et la ou les deuxièmes puces à LED bleues (102, 2, 52) sont chacune (i) une puce à LED bleue qui émet une lumière présentant une longueur d'onde de pointe d'émission qui est située dans une plage de 430 nm à 440 nm et/ou (ii) une puce à LED bleue qui émet une lumière présentant une longueur d'onde de pointe d'émission qui est située dans une plage de 450 nm à 460 nm.

6. Appareil émetteur de lumière (100, 200, 300, 400) pour la culture de plantes tel qu'il est présenté dans la revendication 1, comprenant également :
une paroi en résine (106) disposée de manière à entourer une zone dans laquelle sont disposées la ou les première puces à LED bleues et la ou les deuxièmes puces à LED bleues,
une partie de la zone, entourée par la paroi en résine (106), partie dans laquelle est disposée la première section émettrice de lumière, étant remplie avec la résine (108) dans laquelle est dispersée la substance luminescente rouge (109, 7b),
une partie de la zone, entourée par la paroi en résine (106), partie dans laquelle est disposée la deuxième section émettrice de lumière, étant remplie avec une résine translucide (108) qui scelle la ou les deuxièmes puces à LED bleues.

7. Appareil émetteur de lumière (100, 200, 300, 400, 10, 10A, 10B, 50, 40) pour la culture de plantes tel qu'il est présenté dans la revendication 1, dans lequel un dissipateur de chaleur à ailettes est disposé sur une surface du substrat qui est opposée à une surface sur laquelle sont disposées les première et deuxième sections émettrices de lumière.

8. Appareil émetteur de lumière (100, 200, 300, 400, 10, 10A, 10B, 50, 40) pour la culture de plantes tel qu'il est présenté dans la revendication 1, dans lequel un tube est disposé sur une surface du substrat qui est opposée à une surface sur laquelle sont disposées les première et deuxième sections émettrices de lumière.

9. Procédé de fabrication d'un appareil émetteur de lumière (100, 200, 300, 400, 10, 10A, 10B, 50, 40), comprenant les étapes qui consistent :
(a) à relier à un substrat (101) plusieurs puces à LED bleues (102, 2, 52) émettant chacune une lumière bleue ; et
(b) à former une couche de résine contenant une substance luminescente (107) qui constitue une première section émettrice de lumière qui émet une lumière rouge, dans une première zone sur le substrat de sorte que ladite couche de résine contenant une substance luminescente scelle, avec une résine, l'une au moins des puces à LED bleues (102, 2, 52) qui est disposée dans la première zone, résine dans laquelle est dispersée une substance luminescente rouge (109, 7b) qui émet une lumière rouge lors de la réception d'une lumière d'excitation à partir de l'une au moins des puces LED bleues (102, 2, 52),
une section émettrice de lumière composée de l'une au moins des puces à LED bleues (102, 2, 52), laquelle est disposée dans une deuxième zone voisine de la première zone sur la substrat, servant de deuxième section émettrice de lumière qui émet une lumière bleue,
**caractérisé en ce que** l'appareil émetteur de lumière (100, 200, 300, 400, 10, 10A, 10B, 50, 40) est conçu pour être utilisé pour la culture de plantes et la ou les premières puces à LED bleues (102, 2, 52) qui constituent la première section émettrice de lumière ont une longueur d'onde de pointe d'émission différente de celle d'une ou plusieurs autres puces à LED bleues (102, 2, 52) qui constituent la deuxième section émettrice de lumière.

10. Procédé de fabrication d'un appareil émetteur de lumière (100, 200, 300, 400, 10, 10A, 10B, 50, 40) tel qu'il est présenté dans la revendication 9,
comprenant également, entre les étapes (a) et (b), les étapes qui consistent :
(i) à former une paroi en résine (105, 106) de manière à entourer la première zone et la deuxième zone ; et
(ii) dans la deuxième section émettrice de lumière, à sceller avec une résine translucide (108) la ou les puces à LED bleues (102, 2, 52) qui sont disposées dans la deuxième zone,
lors de l'étape (b), la première zone entourée par la paroi en résine étant remplie avec la résine (107, 7a) dans laquelle est dispersée la substance luminescente rouge (109, 7b) de sorte que la résine couvre la ou les puces à LED bleues (102, 2, 52) qui sont disposées dans la première zone,
lors de l'étape (ii), la deuxième zone entourée par la paroi en résine (105, 106) étant remplie avec la résine translucide de sorte que ladite résine translucide couvre la ou les puces à LED bleues (102, 2, 52) qui sont disposées dans la deuxième zone.

11. Procédé de fabrication d'un appareil émetteur de lumière (100, 200, 300, 400, 10, 10A, 10B, 50, 40) tel qu'il est présenté dans la revendication 9,
la couche de résine contenant une substance luminescente (107, 7a) étant composée de résine silicone ; et
la résine silicone de la couche de résine contenant une substance luminescente de la première section émettrice de lumière étant une résine dont la thixotropie est supérieure à celle de la résine translucide (108) et qui ne présente pas de fluidité.
